# EUROPEAN PATENT APPLICATION

(11) **EP 4 528 790 A1**
(43) Date of publication of application: **26.03.2025**
(21) Application number: 23807381.1
(22) Date of filing: 21.04.2023
(51) Int. Cl.: H01L 21/306, H01L 21/308

(54) **SUBSTRATE PROCESSING METHOD AND SUBSTRATE PROCESSING DEVICE**

(30) Priority: 17.05.2022 JP 2022080692
(71) Applicant: SCREEN Holdings Co., Ltd., Kyoto-shi, Kyoto 602-8585 (JP)
(72) Inventor: HO, Linh Da, Kyoto-shi, Kyoto 602-8585 (JP); INABA, Masaki, Kyoto-shi, Kyoto 602-8585 (JP)
(74) Representative: Kilian Kilian & Partner mbB
(86) International application number: PCT/JP2023/015911
(87) International publication number: WO 2023/223769

(57) **Abstract**

The substrate processing method and the substrate processing apparatus maintains fluoride-containing phosphoric acid at a constant etching temperature that matches or approaches an isokinetic temperature at which, at the concentration of fluoride in the fluoride-containing phosphoric acid, the etch rate of a silicon oxide film O1 and the etch rate of a silicon nitride film N1 are equal to each other by heating the fluoride-containing phosphoric acid which is phosphoric acid that contains fluoride. The method and the apparatus etch the silicon oxide film O1 and the silicon nitride film N1 with the fluoride-containing phosphoric acid by bringing the fluoride-containing phosphoric acid at the etching temperature into contact with the silicon oxide film O1 and the silicon nitride film N1, which have been formed on a substrate W.

## Description

### RELATED APPLICATIONS

This application claims the benefit of priority to Japanese Patent Application No. 2022-080692 filed on May 17, 2022. The entire contents of this application are hereby incorporated herein by reference.

### Technical Field

The present invention relates to a substrate processing method and a substrate processing apparatus that process a substrate. The substrate includes a semiconductor wafer, a substrate for a FPD (Flat Panel Display) such as a liquid crystal display and an organic EL (electroluminescence) display, a substrate for an optical disc, a substrate for a magnetic disc, a substrate for a magneto-optical disc, a substrate for a photomask, a ceramic substrate, a substrate for a solar cell, and the like, for example.

### Background Art

Patent Literature 1 discloses that in manufacturing a three-dimensional NAND device, a phosphoric acid is supplied to a silicon oxide and a silicon nitride and the silicon oxide and silicon nitride are etched at a selectivity greater than 100:1 (with the silicon nitride being 100) .

Patent Literature 2 discloses that a phosphoric acid aqueous solution is supplied to a front surface of a silicon wafer on which a silicon oxide film and a silicon nitride film are exposed and the silicon nitride film is etched while inhibiting etching of the silicon oxide film.

### Citation List

### Patent Literature

Patent Literature 1 : JP 2021-530874 A
Patent Literature 2 : JP 2018-182228 A

### SUMMARY OF INVENTION

### PROBLEMS TO BE SOLVED BY THE INVENTION

In etching a silicon oxide and a silicon nitride upon supplying a phosphoric acid to a substrate such as a semiconductor wafer, etc., it is ordinarily required to etch the silicon nitride at a high selectivity as in Patent Literature 1 and Patent Literature 2. However, there are cases where it is required to etch the silicon oxide and the silicon nitride at equal or substantially equal etch rates using the phosphoric acid. Such a demand cannot be answered with Patent Literature 1 and Patent Literature 2.

An embodiment of the present invention provides a substrate processing method and a substrate processing apparatus by which a silicon oxide and a silicon nitride can be etched at equal or substantially equal etch rates using a phosphoric acid.

### Solution to Problem

An embodiment of the present invention provides a substrate processing method including a phosphoric acid heating step of heating a fluoride-containing phosphoric acid that is a phosphoric acid containing a fluoride to maintain the fluoride-containing phosphoric acid at an etching temperature matching or approaching an isokinetic temperature at which an etch rate of a silicon oxide film and an etch rate of a silicon nitride film at a concentration of the fluoride in the fluoride-containing phosphoric acid are equal to each other and a phosphoric acid supplying step of bringing the fluoride-containing phosphoric acid of the etching temperature into contact with the silicon oxide film and the silicon nitride film that are formed on a substrate to etch the silicon oxide film and the silicon nitride film with the fluoride-containing phosphoric acid.

According to this method, the fluoride-containing phosphoric acid that is the phosphoric acid containing the fluoride is brought into contact with the silicon oxide film and the silicon nitride film that are formed on the substrate to etch the silicon oxide film and the silicon nitride film with the fluoride-containing phosphoric acid. The fluoride-containing phosphoric acid is maintained at the etching temperature matching or approaching the isokinetic temperature at which the etch rate of the silicon oxide film and the etch rate of the silicon nitride film at the concentration of the fluoride in the fluoride-containing phosphoric acid are equal to each other. The silicon oxide film and the silicon nitride film can therefore be etched at equal or substantially equal etch rates.

The isokinetic temperature depends on the concentration of the fluoride in the fluoride-containing phosphoric acid. In a typical substrate processing, the concentration of the fluoride in the fluoride-containing phosphoric acid is kept substantially constant. The isokinetic temperature is thus substantially constant. Accordingly, the fluoride-containing phosphoric acid is maintained at a constant etching temperature.

The silicon oxide film is a thin film of a silicon oxide. The silicon oxide may be a compound in which just Si (silicon) and O (oxygen) are included in a chemical formula or may be compound in which an element besides Si and O are included in the chemical formula. A typical example of the silicon oxide is SiO₂.

The silicon nitride film is a thin film of a silicon nitride. The silicon nitride may be a compound in which just Si (silicon) and N (nitrogen) are included in a chemical formula or may be compound in which an element besides Si and N are included in the chemical formula. A typical example of the silicon nitride is SiN or Si₃N₄. The number of Si included in the chemical formula of the silicon nitride may be a number other than 1 and 3. The number of N included in the chemical formula of the silicon nitride may be a number other than 1 and 4.

The etch rate of the silicon oxide film represents an amount of decrease in thickness of the silicon oxide film per unit time. The same applies to the etch rate of the silicon nitride film. A selectivity of the silicon nitride film with respect to the silicon oxide film expresses a ratio of the etch rate of the silicon nitride film with respect to the etch rate of the silicon oxide film (selectivity of the silicon nitride film with respect to the silicon oxide film = etch rate of the silicon nitride film/etch rate of the silicon oxide film). In the following description, the selectivity of the silicon nitride film with respect to the silicon oxide film is at times referred to simply as the selectivity.

In the embodiment, at least one of the following features may be added to the substrate processing method.

The fluoride is a compound that increases the etch rate of the silicon oxide film and the etch rate of the silicon nitride film. The fluoride is preferably a compound that increases the etch rate of the silicon oxide film and the etch rate of the silicon nitride film as a concentration of the fluoride in the fluoride-containing phosphoric acid increases.

According to this method, the fluoride-containing phosphoric acid of the etching temperature containing the fluoride that increases the etch rate of the silicon oxide film and the etch rate of the silicon nitride film is brought into contact with the silicon oxide film and the silicon nitride film formed on the substrate. Thereby, the silicon oxide film can be etched at a greater etch rate than when the silicon oxide film is etched with a phosphoric acid that does not contain the fluoride and the silicon nitride film can be etched at a greater etch rate than when the silicon nitride film is etched with the phosphoric acid that does not contain the fluoride. Consequently, a processing time of the substrate can be shortened and consumption of energy, such as electric power, etc., can be reduced.

When the concentration of the fluoride in the fluoride-containing phosphoric acid is constant, the etch rate of the silicon oxide film is greater than the etch rate of the silicon nitride film at a temperature lower than the isokinetic temperature and the etch rate of the silicon oxide film is less than the etch rate of the silicon nitride film at a temperature higher than the isokinetic temperature.

According to this method, the fluoride-containing phosphoric acid that changes in selectivity in accordance with temperature is maintained at the isokinetic temperature or a temperature in a vicinity thereof and the fluoride-containing phosphoric acid of this temperature is brought into contact with the silicon oxide film and the silicon nitride film formed on the substrate. When the concentration of the fluoride in the fluoride-containing phosphoric acid is constant, the selectivity is not constant regardless of the temperature of the fluoride-containing phosphoric acid and increases or decreases in accordance with the temperature of the fluoride-containing phosphoric acid. Therefore, by controlling the temperature of the fluoride-containing phosphoric acid, the silicon oxide film and the silicon nitride film can be etched such that the selectivity is 1 or in a vicinity thereof or the silicon oxide film and the silicon nitride film can be etched such that the selectivity exceeds or falls below 1.

The fluoride is ammonium fluoride or ammonium hydrogen difluoride.

According to this method, the fluoride-containing phosphoric acid of the etching temperature that contains ammonium fluoride or ammonium hydrogen difluoride is brought into contact with the silicon oxide film and the silicon nitride film formed on the substrate. Thereby, the silicon oxide film and the silicon nitride film can be etched at equal or substantially equal etch rates. If the fluoride is a fluoride of an alkali metal such as sodium fluoride (NaF) or potassium fluoride (KF), there is a possibility of the substrate becoming contaminated by the metal. There is no such possibility if the fluoride is ammonium fluoride or ammonium hydrogen difluoride. The silicon oxide film and the silicon nitride film can thus be etched as described above while preventing degradation of cleanness of the substrate.

The selectivity that represents a ratio of the etch rate of the silicon nitride film etched in the phosphoric acid supplying step with respect to the etch rate of the silicon oxide film etched in the phosphoric acid supplying step is within a range of 0.9 to 1.1. Such a range of selectivity is an example of a range of selectivity when the etching temperature matches or approaches the isokinetic temperature.

According to this method, the temperature of the fluoride-containing phosphoric acid is adjusted such that the selectivity (etch rate of the silicon nitride film/etch rate of the silicon oxide film) takes on a value within the range of 0.9 to 1.1 and the fluoride-containing phosphoric acid of this temperature is brought into contact with the silicon oxide film and the silicon nitride film formed on the substrate. The silicon oxide film and the silicon nitride film are etched at the selectivity within the range of 0.9 to 1.1. Thereby, it is prevented that the silicon nitride film is etched at an etch rate greater than the etch rate of the silicon oxide film while the silicon oxide film is hardly etched as in when the silicon oxide film and the silicon nitride film are etched with the phosphoric acid not containing the fluoride.

The substrate includes a plurality of the silicon oxide films and a plurality of the silicon nitride films that are laminated in a thickness direction of the substrate such that the silicon oxide films and the silicon nitride films are interchanged alternately and a hole that is recessed in the thickness direction from a frontmost surface of the substrate and penetrates through the plurality of silicon oxide films and the plurality of the silicon nitride films in the thickness direction and the phosphoric acid supplying step includes a step of bringing the fluoride-containing phosphoric acid of the etching temperature into contact with the plurality of silicon oxide films and the plurality of the silicon nitride films that are exposed inside the hole.

According to this method, the fluoride-containing phosphoric acid of the etching temperature is supplied into the hole that penetrates through the plurality of silicon oxide films and the plurality of the silicon nitride films in the thickness direction of the substrate. The fluoride-containing phosphoric acid contacts the plurality of silicon oxide films and the plurality of the silicon nitride films that constitute an inner circumferential surface of the hole and etches these films. If a vertical cross section of the inner circumferential surface of the hole (a cross section of sectioning in a plane parallel to the thickness direction of the substrate and containing a center line of the hole) before etching is of a rectilinear shape, the vertical cross section of the inner circumferential surface of the hole changes to a wavy line shape in some cases where the inner circumferential surface of the hole is etched with the phosphoric acid not containing the fluoride. By supplying the fluoride-containing phosphoric acid of the etching temperature into the hole, such change can be prevented or alleviated.

A diameter of the hole changes in accordance with position in the thickness direction of the substrate.

According to this method, the fluoride-containing phosphoric acid of the etching temperature is supplied into the hole that changes in diameter in accordance with position in the thickness direction of the substrate. The inner circumferential surface of the hole can thereby be etched with the fluoride-containing phosphoric acid while maintaining the shape of the vertical cross section of the inner circumferential surface of the hole. When the inner circumferential surface of the hole is etched with an etching liquid, the etch rate tends to decrease as a bottom of the hole is approached because the etching liquid becomes less likely to be renewed as the bottom of the hole is approached. If the diameter of the hole increases as the bottom of the hole is approached, variation in the diameter of the hole can be alleviated while maintaining the shape of the vertical cross section of the inner circumferential surface of the hole by etching the inner circumferential surface of the hole with the fluoride-containing phosphoric acid.

The inner circumferential surface of the hole may be of a shape with which the diameter of the hole decreases or increases continuously or stepwise from the frontmost surface of the substrate to the bottom of the hole as the bottom of the hole is approached. Or, the inner circumferential surface of the hole may include at least one of a portion in which the diameter of the hole decreases continuously or stepwise as the bottom of the hole is approached and a portion in which the diameter of the hole increases continuously or stepwise as the bottom of the hole is approached.

The substrate processing method further includes an inner circumferential surface protecting step of covering a range, in the thickness direction of the substrate, of a portion of the inner circumferential surface of the hole with a protective substance of solid, liquid, or semisolid state that protects the silicon oxide film and the silicon nitride film from the fluoride-containing phosphoric acid and the phosphoric acid supplying step includes a step of bringing the fluoride-containing phosphoric acid of the etching temperature into contact with a remaining portion of the inner circumferential surface of the hole not covered by the protective substance while protecting the range of the portion from the fluoride-containing phosphoric acid of the etching temperature by the protective substance.

According to this method, an entirety of the range, in the thickness direction of the substrate, of the portion of the inner circumferential surface of the hole is covered with the protective substance before supplying the fluoride-containing phosphoric acid of the etching temperature into the hole that changes in diameter in accordance with position in the thickness direction of the substrate and thereafter, the fluoride-containing phosphoric acid of the etching temperature is brought into contact with the remaining portion of the inner circumferential surface of the hole that is not covered by the protective substance. The remaining portion of the inner circumferential surface of the hole can thereby be etched selectively and the shape of the hole can be changed intentionally.

If the diameter of the hole "decreases" from the frontmost surface of the substrate to the bottom of the hole as bottom of the hole is approached, the variation in the diameter of the hole can be alleviated by protecting an entrance side portion of the inner circumferential surface of the hole with the protective substance and etching a bottom side portion of the inner circumferential surface of the hole with the fluoride-containing phosphoric acid. On the other hand, if the diameter of the hole "increases" from the frontmost surface of the substrate to the bottom of the hole as bottom of the hole is approached, the variation in the diameter of the hole can be alleviated by protecting the bottom side portion of the inner circumferential surface of the hole with the protective substance and etching the entrance side portion of the inner circumferential surface of the hole with the fluoride-containing phosphoric acid.

As long as a state in which the range, in the thickness direction of the substrate, of the portion of the inner circumferential surface of the hole is covered with the protective substance is maintained when the fluoride-containing phosphoric acid is supplied to the substrate, the protective substance may be of any of a solid, liquid, and semisolid states. The protective substance may be a protective film of cylindrical shape that is coaxial to the inner circumferential surface of the hole or may be a protective plug that fills an entirety of a region of an inner side of the inner circumferential surface of the hole. The remaining portion of the inner circumferential surface of the hole not covered by the protective substance may be a portion further to a bottom side than the protective substance or may be a portion further to an entrance side of the hole (a frontmost surface side of the substrate) than the protective substance.

The substrate processing method further includes a substrate heating step of heating the substrate to maintain the substrate at a constant temperature before bringing the fluoride-containing phosphoric acid of the etching temperature into contact with the silicon oxide film and the silicon nitride film formed on the substrate.

According to this method, the substrate is heated and maintained at the constant temperature before the fluoride-containing phosphoric acid that is maintained at the etching temperature by heating is brought into contact with the substrate. Thereby, the silicon oxide film and the silicon nitride film can be etched in a short time in comparison to a case where the fluoride-containing phosphoric acid of the etching temperature is supplied to the substrate of room temperature. Further, the temperature of the substrate before contact with the fluoride-containing phosphoric acid is stabilized and therefore, when a plurality of substrates are successively brought into contact with the fluoride-containing phosphoric acid of the etching temperature, an etching amount can be stabilized among the plurality of substrates.

Another embodiment of the present invention for achieving the above object provides a substrate processing apparatus that includes a heater heating a fluoride-containing phosphoric acid that is a phosphoric acid containing a fluoride to maintain the fluoride-containing phosphoric acid at an etching temperature matching or approaching an isokinetic temperature at which an etch rate of a silicon oxide film and an etch rate of a silicon nitride film at a concentration of the fluoride in the fluoride-containing phosphoric acid are equal to each other and a chemical liquid nozzle discharging the fluoride-containing phosphoric acid of the etching temperature and by contact of the discharged fluoride-containing phosphoric acid of the etching temperature and the silicon oxide film and the silicon nitride film that are formed on a substrate, etches the silicon oxide film and the silicon nitride film with the fluoride-containing phosphoric acid. According to this apparatus, the same effects as the substrate processing method described above can be exhibited.

The above and other objects, features, and advantages of the present invention will become more apparent from the following detailed description of the preferred embodiments with reference to the attached drawings.

### BRIEF DESCRIPTION OF THE DRAWINGS

[FIGS. 1A-D] sectional views of a substrate for describing an example of processing of the substrate according to an embodiment.
[FIGS. 1E-H] sectional views of the substrate for describing the example of processing of the substrate according to the embodiment.
[FIG. 2] a sectional view of the substrate showing an illustrative image of an inner circumferential surface of a memory hole before and after etching with a phosphoric acid not containing a fluoride.
[FIG. 3] a sectional view of the substrate showing an illustrative image of the inner circumferential surface of the memory hole before and after etching with a fluoride-containing phosphoric acid.
[FIG. 4] a broken line graph showing relationships between a concentration of a fluoride in the fluoride-containing phosphoric acid and etch rates of a silicon oxide film and a silicon nitride film.
[FIG. 5] a broken line graph showing relationships between the concentration of the fluoride in the fluoride-containing phosphoric acid and the etch rates of the silicon oxide film and the silicon nitride film.
[FIG. 6] a broken line graph showing relationships between a temperature of the fluoride-containing phosphoric acid and the etch rates of the silicon oxide film and the silicon nitride film.
[FIG. 7] a broken line graph showing relationships between the temperature of the fluoride-containing phosphoric acid and the etch rates of the silicon oxide film and the silicon nitride film.
[FIG. 8] a schematic plan view showing a layout of a batch type substrate processing apparatus according to an embodiment of the present invention.
[FIG. 9] a schematic view showing an example of a vertical cross section of a chemical liquid processing bath.
[FIG. 10] a schematic view showing another example of a vertical cross section of a chemical liquid processing bath.
[FIG. 11A] a schematic plan view showing a layout of a single substrate processing type substrate processing apparatus according to an embodiment of the present invention.
[FIG. 11B] a schematic side view of the single substrate processing type substrate processing apparatus.
[FIG. 12] a schematic view of an interior of a processing unit when viewed horizontally.

### DETAILED DESCRIPTION OF PREFERRED EMBODIMENTS

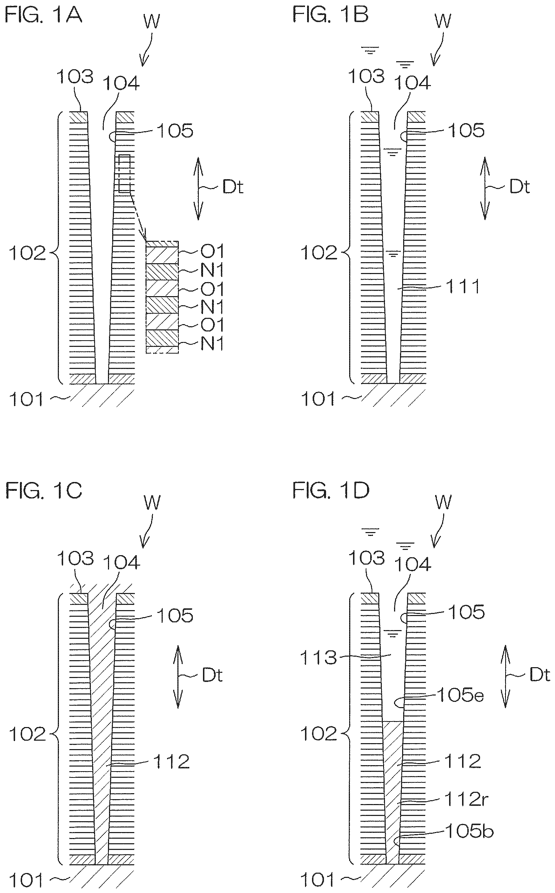

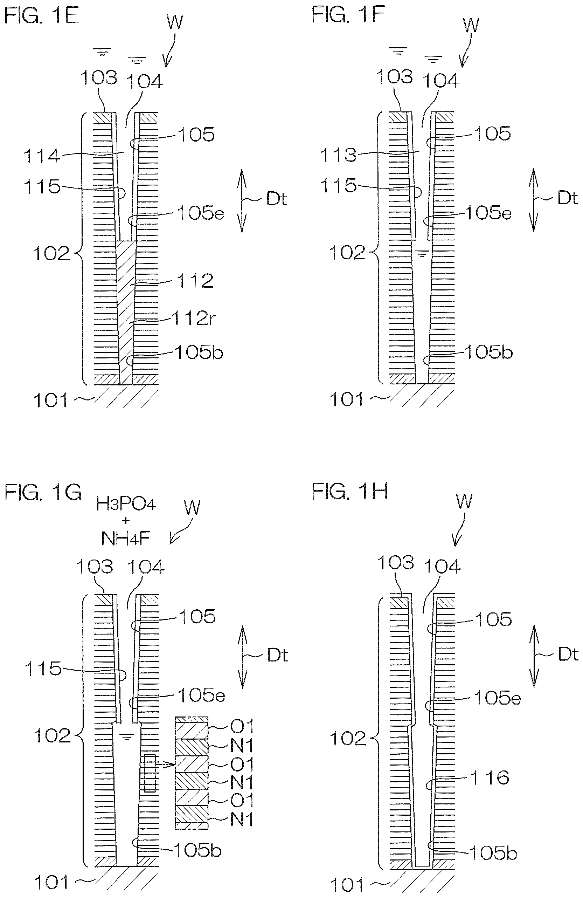

FIG. 1A, FIG. 1B, FIG. 1C, FIG. 1D, FIG. 1E, FIG. 1F, FIG. 1G, and FIG. 1H are sectional views of a substrate W for describing an example of processing of the substrate W according to an embodiment.

FIG. 1A to FIG. 1H show a cross section of sectioning the substrate W in a plane perpendicular to a front surface of the substrate W. In the following, an example where the processing of the substrate W is a portion of a manufacturing process of a three-dimensional NAND type flash memory shall be described. In the following description, a phosphoric acid means a phosphoric acid aqueous solution unless noted in particular otherwise. However, a concentration of the phosphoric acid means a concentration of a compound of phosphoric acid (H₃PO₄).

As shown in FIG. 1A, the substrate W includes a plate-shaped base material 101 such as a silicon wafer , a laminated film 102 that is formed on the base material 101, and a memory hole 104 that is recessed in a thickness direction Dt of the substrate W from a frontmost surface of the laminated film 102 corresponding to a frontmost surface 103 of the substrate W. The laminated film 102 is a portion that constitutes a memory cell array of the three-dimensional NAND type flash memory. The memory cell array is a portion that includes a plurality of memory cells that are arrayed three-dimensionally in three orthogonal directions.

The laminated film 102 includes a plurality of silicon oxide films O1 and a plurality of silicon nitride films N1 that are laminated in the thickness direction Dt of the substrate W such that the silicon oxide films O1 that are thin films of silicon oxide and the silicon nitride films N1 that are thin films of silicon nitride are interchanged alternately. The memory hole 104 penetrates through the plurality of silicon oxide films O1 and the plurality of silicon nitride films N1 in the thickness direction Dt of the substrate W. The memory hole 104 is formed by dry etching such as reactive ion etching, etc.

At least a portion of an inner circumferential surface 105 of the memory hole 104 is constituted of inner circumferential surfaces of the plurality of silicon oxide films O1 and inner circumferential surfaces of the plurality of silicon nitride films N1 that are continuous in the thickness direction Dt of the substrate W such that the inner circumferential surfaces of the silicon oxide films O1 and the inner circumferential surfaces of the silicon nitride films N1 are interchanged alternately. FIG. 1A shows an example where a diameter of the memory hole 104 decreases continuously from the frontmost surface 103 of the substrate W to a bottom of the memory hole 104 as the bottom of the memory hole 104 is approached. A lateral cross section of the memory hole 104, that is, a cross section of the memory hole 104 along a plane orthogonal to the thickness direction Dt of the substrate W is of a circular shape.

As shown in FIG. 1B, in the example of processing of the substrate W according to the present embodiment, a filling liquid 111 is supplied to the substrate W with the memory hole 104 formed therein and the memory hole 104 is filled with the filling liquid 111. Thereafter, as shown in FIG. 1C, the filling liquid 111 inside the memory hole 104 is changed to a filling substance 112 and the memory hole 104 is filled with the filling substance 112. FIG. 1C shows a state where an entirety of the memory hole 104 is filled with the filling substance 112. The filling substance 112 may be a solid or may be of a semisolid state that includes a liquid.

The filling liquid 111 changes to a solid state or a semisolid state, for example, by any of precipitation, coagulation, and solidification. Precipitation means changing of a solute dissolved in a solvent to a solid by a concentration of the solute exceeding a saturation concentration due to evaporation of the solvent. Coagulation means a change from a liquid phase to a solid phase due to decrease in temperature to not more than a coagulation point. Solidification means a change from a liquid to a solid due to a chemical change upon receiving supply of energy such as heat or light. After the filling liquid 111 is supplied to the substrate W, the filling liquid 111 is changed to the solid state or the semisolid state by any of precipitation, coagulation, and solidification and the filling liquid 111 is changed to the filling substance 112.

The filling liquid 111 may be a solution that contains a solute and a solvent. As the solute, at least one type selected from a group consisting of thermosensitive water-soluble resins, acrylic resins, phenol resins, epoxy resins, melamine resins, urea resins, unsaturated polyester resins, alkyd resins, polyurethane, polyimide, polyethylene, polypropylene, polyvinylchloride, polystyrene, polyvinyl acetate, polytetrafluoroethylene, acrylonitrile butadiene styrene resins, acrylonitrile styrene resins, polyamide, polyacetal, polycarbonate, polyvinyl alcohol, modified polyphenylene ether, polybutylene terephthalate, polyethylene terephthalate, polyphenylene sulfide, polysulfone, polyether ether ketone, and polyamide-imide can be used. The thermosensitive water-soluble resins are resins having a property of being poorly soluble or insoluble in water before heating to not less than a predetermined alteration temperature and being altered and becoming water-soluble by being heated to not less than the alteration temperature. The solvent preferably has a higher volatility than water. As the solvent, it is preferable to use PGEE (polypropylene glycol monoethyl ether).

The filling liquid 111 may contain a sublimable substance. As the sublimable substance, any of various substances that is high in vapor pressure at 5°C to 35°C and changes from a solid phase to a gas phase without passing through a liquid phase is used. As the sublimable substance, for example, hexamethylenetetramine, 1,3,5-trioxane, ammonium 1-pyrrolidine carbodithioate, metaldehyde, paraffin with approximately 20 to 48 carbon atoms, t-butanol, para-dichlorobenzene, naphthalene, L-menthol, or a fluorohydrocarbon compound, etc., is used. In particular, a fluorohydrocarbon compound may be used as the sublimable substance. It is especially preferable to use 1,1,2,2,3,3,4-heptafluorocyclopentane as the sublimable substance.

As the solvent, for example, at least one type selected from among the group consisting of pure water (deionized water: DIW), aliphatic hydrocarbons, aromatic hydrocarbons, ester, alcohols, and ethers can be used. Specifically, as the solvent, for example, at least one type selected from among the group consisting of pure water, methanol, ethanol, IPA, butanol, ethylene glycol, propylene glycol, NMP (N-methyl-2-pyrrolidone), DMF (N,N-dimethylformamide), DMA (dimethylacetamide), DMSO (dimethylsulfoxide), hexane, toluene, PGMEA (propylene glycol monomethyl ether acetate), PGME (propylene glycol monomethyl ether), PGPE (propylene glycol monopropyl ether), PGEE (propylene glycol monoethyl ether), GBL (γ-butyrolactone), acetylacetone, 3-pentanone, 2-heptanone, ethyl lactate, cyclohexanone, dibutyl ether, HFE (hydrofluoroether), ethyl nonafluoroisobutyl ether, ethyl nonafluorobutyl ether, and m-xylene hexafluoride can be used.

After the filling substance 112 has been formed inside the memory hole 104, a removing liquid 113 that dissolves the filling substance 112 is supplied to the substrate W and the filling substance 112 inside the memory hole 104 is removed with the removing liquid 113 while leaving the filling substance 112 at the bottom side of the memory hole 104 as shown in FIG. 1D. The removing liquid 113 supplied to the substrate W contacts the filling substance 112 inside the memory hole 104 and dissolves the filling substance 112 from an entrance side of the memory hole 104 toward the bottom of the memory hole 104. Thereby, an end surface of the filling substance 112 moves to the bottom side of the memory hole 104 and a height of the filling substance 112 decreases gradually.

As the removing liquid 113, for example, an organic solvent, such as a thinner, toluene, an acetate ester, an alcohol, a glycol, etc., or an acidic liquid, such as acetic acid, formic acid, hydroxyacetic acid, etc., can be used. In particular, as the removing liquid 113, it is preferable to use a solvent having compatibility with a water-based liquid. For example, it is preferable to use isopropyl alcohol (IPA) as the removing liquid 113.

When a time during which the filling substance 112 is removed from a range from an entrance of the memory hole 104 to a middle of the memory hole 104 and the filling substance 112 remains in a range from the middle of the memory hole 104 to the bottom of the memory hole 104 elapses, the removing liquid 113 is removed from the substrate W. The removal of the removing liquid 113 may be performed by replacing the removing liquid 113 in contact with the substrate W with a liquid such as pure water or a protective liquid 114 to be described later, etc. A distance from the entrance of the memory hole 104 to the middle of the memory hole 104 may be equal to or may differ from a distance from the middle of the memory hole 104 to the bottom of the memory hole 104.

The filling substance 112 remaining in the memory hole 104 after the removing liquid 113 has been removed from the substrate W shall be defined as a residual filling substance 112r. A portion of the inner circumferential surface 105 of the memory hole 104 that is not in contact with the residual filling substance 112r and a portion of the inner circumferential surface 105 of the memory hole 104 that is in contact with the residual filling substance 112r shall be defined respectively as an entrance side portion 105e of the inner circumferential surface 105 of the memory hole 104 and a bottom side portion 105b of the inner circumferential surface 105 of the memory hole 104. At least a portion of the entrance side portion 105e is constituted of the inner circumferential surfaces of a plurality of the silicon oxide films O1 and the inner circumferential surfaces of a plurality of the silicon nitride films N1. At least a portion of the bottom side portion 105b is constituted of the inner circumferential surfaces of another plurality of the silicon oxide films O1 and the inner circumferential surfaces of another plurality of the silicon nitride films N1.

After the portion of the filling substance 112 inside the memory hole 104 has been removed, the protective liquid 114 is supplied to the substrate W and a protective film 115 that is an example of a protective substance is formed on the entrance side portion 105e of the inner circumferential surface 105 of the memory hole 104 as shown in FIG. 1E. Since the filling substance 112 remains at the bottom side of the memory hole 104, when the protective liquid 114 is supplied to the substrate W, an entrance side region of the memory hole 104, that is, a region inside the memory hole 104 further to the entrance side of the memory hole 104 than the residual filling substance 112r is filled with the protective liquid 114 and the entrance side portion 105e of the inner circumferential surface 105 of the memory hole 104 and the end surface of the residual filling substance 112r contact the protective liquid 114.

The protective liquid 114 is a liquid of a water repellent agent that hydrophobizes silicon (Si) itself and compounds containing silicon, for example. Typically, the water repellent agent is a silane coupling agent. In one example, the silane coupling agent includes at least one among HMDS (hexamethyldisilazane), TMS (tetramethylsilane), a fluorinated alkylchlorosilane, an alkyldisilazane, and a non-chloro-based water repellent agent. The non-chloro-based water repellent includes, for example, at least one among dimethylsilyldimethylamine, dimethylsilyldiethylamine, hexamethyldisilazane, tetramethyldisilazane, bis(dimethylamino)dimethylsilane, N,N-dimethylaminotrimethylsilane, N-(trimethylsilyl)dimethylamine, and an organosilane compound.

The protective liquid 114 attaches to the plurality of silicon oxide films O1 and the plurality of silicon nitride films N1 constituting the entrance side portion 105e of the inner circumferential surface 105 of the memory hole 104 and forms the protective film 115 on the entrance side portion 105e of the inner circumferential surface 105 of the memory hole 104. The protective film 115 is a liquid film of cylindrical shape that is coaxial to the inner circumferential surface 105 of the memory hole 104 and contacts an entire region of the entrance side portion 105e of the inner circumferential surface 105 of the memory hole 104. Although in FIG. 1E, a boundary is indicated between the protective liquid 114 and the protective film 115 to facilitate understanding, such a boundary does not exist in actuality.

When the protective liquid 114 contacts the entrance side portion 105e of the inner circumferential surface 105 of the memory hole 104 and the protective film 115 is formed on the entrance side portion 105e of the inner circumferential surface 105 of the memory hole 104, the protective liquid 114 is removed from the substrate W. The removal of the protective liquid 114 may be performed by replacing the protective liquid 114 with a liquid such as pure water, etc. Even when the protective liquid 114 is removed from the substrate W, the protective liquid 114 remains on the entrance side portion 105e of the inner circumferential surface 105 of the memory hole 104.

After the protective liquid 114 has been brought into contact with the entrance side portion 105e of the inner circumferential surface 105 of the memory hole 104, the filling substance 112 is removed from a bottom side region of the memory hole 104, that is, a region inside the memory hole 104 occupied by the residual filling substance 112r while leaving the protective film 115 on the entrance side portion 105e of the inner circumferential surface 105 of the memory hole 104 as shown in FIG. 1F. The removal of the residual filling substance 112r may be performed by supplying the removing liquid 113 to the substrate W as shown in FIG. 1F. In this case, the protective liquid 114 inside the memory hole 104 may be replaced with the removing liquid 113. The removal of the residual filling substance 112r may be performed by heating the substrate W. If the residual filling substance 112r includes a sublimable substance, the residual filling substance 112r may be sublimated by heating of the substrate W.

As shown in FIG. 1F, when the residual filling substance 112r is removed from the memory hole 104, the bottom side portion 105b of the inner circumferential surface 105 of the memory hole 104 becomes exposed from the filling substance 112 in a state where the entrance side portion 105e of the inner circumferential surface 105 of the memory hole 104 is covered with the protective film 115. In this state, a fluoride-containing phosphoric acid is supplied to the substrate W as shown in FIG. 1G. FIG. 1G shows an example where a fluoride contained in the fluoride-containing phosphoric acid is ammonium fluoride (NH₄F). The fluoride-containing phosphoric acid supplied to the substrate W enters inside the memory hole 104 from the entrance of the memory hole 104 and passes through an inner side of the protective film 115 of cylindrical shape. Thereby, the bottom side region of the memory hole 104 and a region of the inner side of the protective film 115 are filled with the fluoride-containing phosphoric acid.

The fluoride-containing phosphoric acid is a phosphoric acid that contains a fluoride (to be exact, a phosphoric acid aqueous solution that contains a fluoride). The fluoride-containing phosphoric acid is an example of a chemical liquid that reacts chemically with the substrate W. The fluoride-containing phosphoric acid is also an example of an etching liquid that etches the substrate W. The fluoride contained in the fluoride-containing phosphoric acid may be a solid fluoride that is dissolved in the phosphoric acid or may be a fluoride contained in a fluoride-containing liquid (a liquid of a fluoride or a solution in which a fluoride is dissolved) that is mixed with the phosphoric acid.

The fluoride contained in the fluoride-containing phosphoric acid is ammonium fluoride (NH₄F) or ammonium bifluoride (NH₄HF₂). When the fluoride is ammonium fluoride, a concentration of the fluoride in the fluoride-containing phosphoric acid is 0.15 to 1.5 wt% (mass percent concentration). A concentration of the phosphoric acid (a concentration of the phosphoric acid in the phosphoric acid aqueous solution) before adding the fluoride is 85%. The concentration of the phosphoric acid and the concentration of the fluoride are not limited to the above.

The plurality of silicon oxide films O1 and the plurality of silicon nitride films N1 that constitute the entrance side portion 105e of the inner circumferential surface 105 of the memory hole 104 are protected from the fluoride-containing phosphoric acid by the protective film 115. On the other hand, the plurality of silicon oxide films O1 and the plurality of silicon nitride films N1 that constitute the bottom side portion 105b of the inner circumferential surface 105 of the memory hole 104 contact the fluoride-containing phosphoric acid and are etched with the fluoride-containing phosphoric acid. As shall be described below, the fluoride-containing phosphoric acid is supplied to the substrate W in a processing condition with which the silicon oxide films O1 and the silicon nitride films N1 are etched at equal or substantially equal etch rates. Therefore, whereas the bottom side portion 105b of the inner circumferential surface 105 of the memory hole 104 is etched, the entrance side portion 105e of the inner circumferential surface 105 of the memory hole 104 is not etched or is hardly etched.

The bottom side portion 105b of the inner circumferential surface 105 of the memory hole 104 is etched at all positions in a circumferential direction of the memory hole 104 and is etched at all positions in a depth direction of the memory hole 104 that matches the thickness direction Dt of the substrate W. Therefore, although a height of the bottom side portion 105b of the inner circumferential surface 105 of the memory hole 104 (shortest distance in the thickness direction Dt of the substrate W from the bottom of the memory hole 104 to the protective film 115) does not change or hardly changes, a diameter of the bottom side portion 105b of the inner circumferential surface 105 of the memory hole 104 increases at all position in the thickness direction Dt of the substrate W. The bottom side portion 105b of the inner circumferential surface 105 of the memory hole 104 after etching is of a cylindrical shape coaxial to the bottom side portion 105b of the inner circumferential surface 105 of the memory hole 104 before etching.

FIG. 1A shows an example where the memory hole 104 is tapered toward the bottom of the memory hole 104. In this example, before the fluoride-containing phosphoric acid is supplied to the substrate W, the diameter of the memory hole 104 is maximum near the entrance of the memory hole 104 and is minimum near the bottom of the memory hole 104. When the fluoride-containing phosphoric acid is supplied to the substrate W, whereas the diameter of the entrance side portion 105e of the inner circumferential surface 105 of the memory hole 104 does not change or hardly changes, the diameter of the bottom side portion 105b of the inner circumferential surface 105 of the memory hole 104 increases due to the etching of the silicon oxide films O1 and the silicon nitride films N1. A minimum value of the diameter of the memory hole 104 approaches a maximum value of the diameter of the memory hole 104. Thereby, a difference between the maximum value and the minimum value of the diameter of the memory hole 104 decreases.

When a predetermined time elapses from when the supply of the fluoride-containing phosphoric acid to the substrate W is started, the fluoride-containing phosphoric acid is removed from the substrate W. The removal of the fluoride-containing phosphoric acid may be performed by replacing the fluoride-containing phosphoric acid in contact with the substrate W with a liquid such as a rinse liquid, etc. The protective film 115 may be removed by heating of the substrate W or irradiation of the substrate W with ultraviolet rays, etc., after removing the fluoride-containing phosphoric acid or while removing the fluoride-containing phosphoric acid. If there is no influence on characteristics of the three-dimensional NAND type flash memory, the protective film 115 may be left on.

After the fluoride-containing phosphoric acid has been removed from the substrate W, a thin film 116 that is a portion of the three-dimensional NAND type flash memory is deposited by vapor phase deposition such as chemical vapor phase deposition on an entire region of the inner circumferential surface 105 of the memory hole 104 as shown in FIG. 1H. The thin film 116 in contact with the inner circumferential surface 105 of the memory hole 104 is a portion that constitutes a plurality of memory cells that are arrayed in the thickness direction Dt of the substrate W. The thin film 116 may be a conductive film such as a polysilicon film, etc., or may be an insulating film such as a silicon oxide film, etc. The silicon nitride films N1 may be sacrificial films that are replaced by thin films such as metal films, etc., after the thin film 116 has been deposited on the inner circumferential surface 105 of the memory hole 104.

The series of steps after forming the memory hole 104 and prior to depositing the thin film 116 on the inner circumferential surface 105 of the memory hole 104 constitute a hole shape modification step of modifying the shape of the memory hole 104 by wet etching. The hole shape modification step is performed by a wet process of bringing a processing liquid into contact with the substrate W. On the other hand, the memory hole 104 is formed by dry etching, which is an example of a dry process. The thin film 116 in contact with the inner circumferential surface 105 of the memory hole 104 is also formed by vapor phase deposition, which is an example of a dry process.

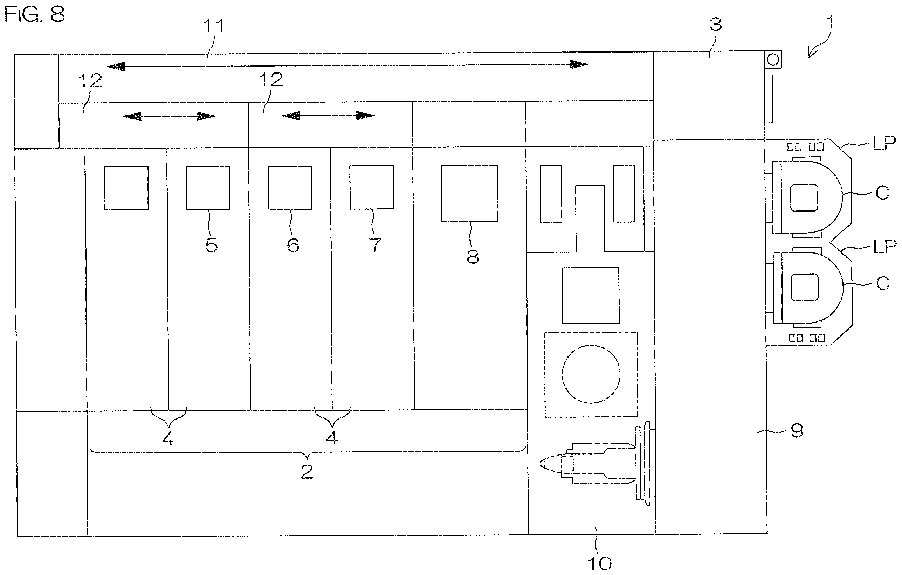

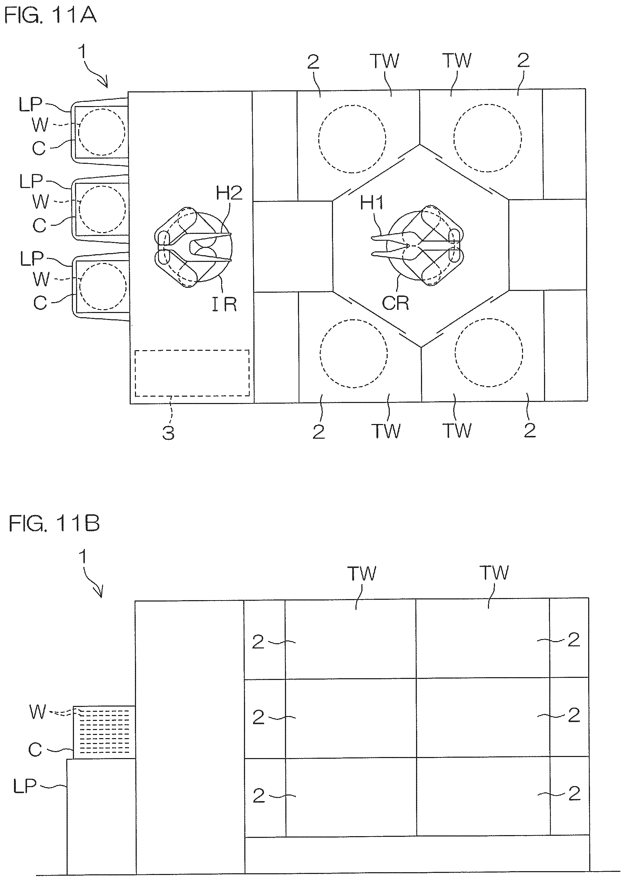

The hole shape modification step may be performed by a single substrate processing apparatus 1 (see FIG. 8 and FIG. 11) or may be performed by a plurality of substrate processing apparatuses 1. The hole shape modification step may be performed by the substrate processing apparatus 1 of a batch type that processes a plurality of substrates W in a batch or the substrate processing apparatus 1 of a single substrate processing type that processes the plurality of substrates W one at a time or may be performed by the substrate processing apparatus 1 of the batch type and the substrate processing apparatus 1 of the single substrate processing type. A portion of the hole shape modification step may be performed by a dry process. For example, instead of the protective liquid 114, a protective gas may be brought into contact with the entrance side portion 105e of the inner circumferential surface 105 of the memory hole 104 to form the protective film 115 of solid, liquid, or semisolid state by a substance contained in the protective gas on the entrance side portion 105e of the inner circumferential surface 105 of the memory hole 104.

Next, a cross section of the substrate W before and after etching shall be described.

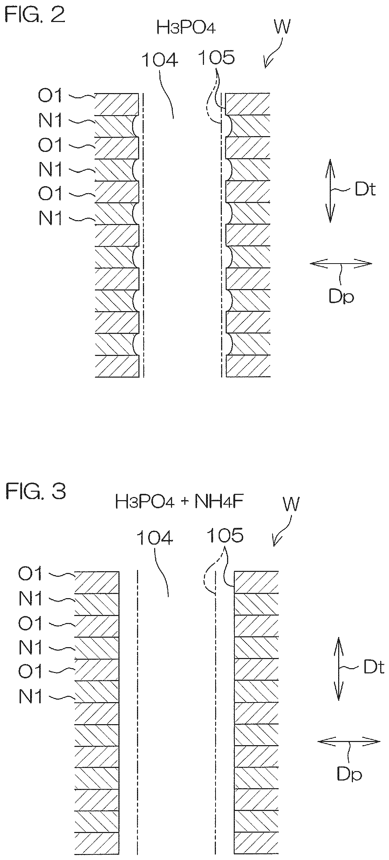

FIG. 2 is a sectional view of the substrate W showing an illustrative image of the inner circumferential surface 105 of the memory hole 104 before and after etching with a phosphoric acid not containing a fluoride (hereinafter referred to simply as the "phosphoric acid"). FIG. 3 is a sectional view of the substrate W showing an illustrative image of the inner circumferential surface 105 of the memory hole 104 before and after etching with the fluoride-containing phosphoric acid that contains the fluoride.

In FIG. 2 and FIG. 3, the inner circumferential surface 105 of the memory hole 104 before etching is indicated by alternate long and two short dashed lines and the inner circumferential surface 105 of the memory hole 104 after etching is indicated by solid lines. The shapes of the inner circumferential surface 105 of the memory hole 104 before and after etching are strictly illustrative images and may differ from actual shapes. FIG. 3 shows an example where the fluoride contained in the fluoride-containing phosphoric acid is ammonium fluoride (NH₄F).

At least a portion of the inner circumferential surface 105 of the memory hole 104 is constituted of the inner circumferential surfaces of the plurality of silicon oxide films O1 and the inner circumferential surfaces of the plurality of silicon nitride films N1 that are continuous in the thickness direction Dt of the substrate W such that the inner circumferential surfaces of the silicon oxide films O1 and the inner circumferential surfaces of the silicon nitride films N1 are interchanged alternately. When the phosphoric acid is supplied to the memory hole 104, whereas the silicon oxide films O1 are not etched or are hardly etched with the phosphoric acid, the silicon nitride films N1 are etched with the phosphoric acid at an etch rate greater than an etch rate of the silicon oxide films O1.

As shown in FIG. 2, when the inner circumferential surface 105 of the memory hole 104 is etched with the phosphoric acid, the diameter of the memory hole 104 does not change or hardly changes at position of the plurality of silicon oxide films O1 but increases at positions of the plurality of silicon nitride films N1. If the diameter of the memory hole 104 before etching is uniform as indicated by the alternate long and two short dashed lines in FIG. 2, a vertical cross section of the inner circumferential surface 105 of the memory hole 104 (a cross section of sectioning in a plane parallel to the thickness direction Dt of the substrate W and containing a center line of the memory hole 104) changes from a rectilinear shape to a wavy line shape when the inner circumferential surface 105 of the memory hole 104 is etched with the phosphoric acid. In this case, the inner circumferential surface 105 of the memory hole 104 changes to a cylindrical shape in which the diameter decreases at the positions of the plurality of silicon oxide films O1 and the diameter increases at the positions of the plurality of silicon nitride films N1.

The thin film 116 (see FIG. 1H) that becomes a portion of the three-dimensional NAND type flash memory is formed on the inner circumferential surface 105 of the memory hole 104. The vertical cross section of the inner circumferential surface 105 of the memory hole 104 is preferably as small in undulation as possible. In addition, the diameter of the memory hole 104 is preferably as uniform as possible. FIG. 3 shows an example where the diameter of the memory hole 104 is uniform even after etching and the undulation of the vertical cross section of the inner circumferential surface 105 of the memory hole 104 is small even after etching. In this example, the inner circumferential surface 105 of the memory hole 104 is etched with the vertical cross section of the inner circumferential surface 105 of the memory hole 104 being maintained in the rectilinear shape.

As shall be described below, the fluoride-containing phosphoric acid is supplied to the inner circumferential surface 105 of the memory hole 104 under the processing condition with which the silicon oxide films O1 and the silicon nitride films N1 are etched at equal or substantially equal etch rates. Thereby, not just the silicon nitride films N1 but the silicon oxide films O1 can also be etched at a sufficient etch rate, and a plurality of recesses of ring shape that are recessed in a plane direction Dp of the substrate W (a direction perpendicular to the thickness direction Dt of the substrate W) can be prevented from being formed in the inner circumferential surface 105 of the memory hole 104 at the positions of the plurality of silicon nitride films N1. Even if such recesses are formed, the recesses can be made shallow.

Next, relationships between the concentration of the fluoride or the temperature of the fluoride-containing phosphoric acid and the etch rates shall be described.

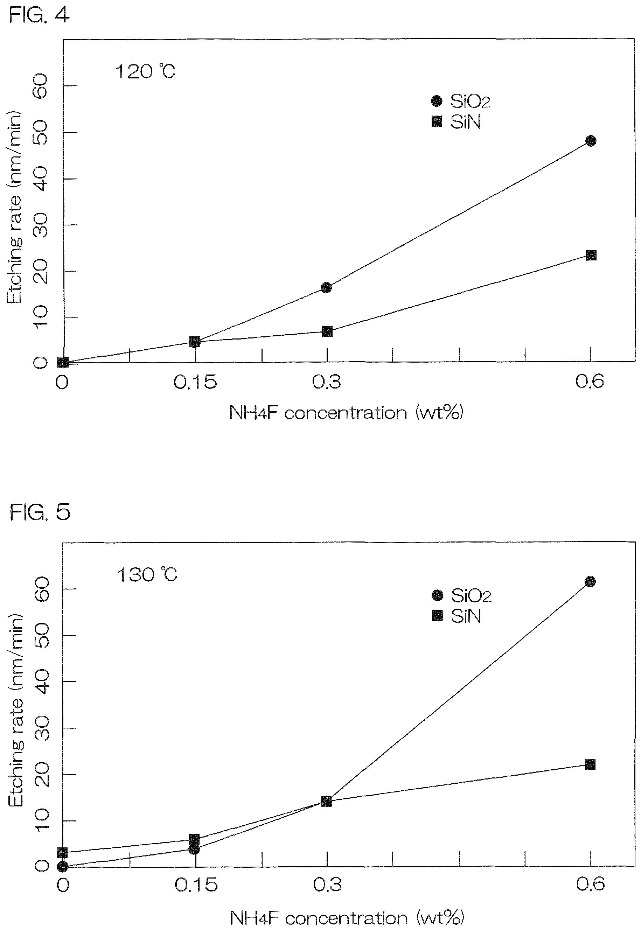

FIG. 4 to FIG.7 are broken line graphs showing measured values of the etch rates when a silicon oxide film O1 and a silicon nitride film are etched using the fluoride-containing phosphoric acid.

FIG. 4 to FIG. 7 show the etch rates when the silicon oxide film and the silicon nitride film are etched using solutions with which ammonium fluoride is added to the phosphoric acid of 85% (the phosphoric acid aqueous solution with which the concentration of the phosphoric acid is 85%). In FIG. 4 to FIG. 7, the ordinate indicates the etch rate and the abscissa indicates the concentration of ammonium fluoride or the temperature of the fluoride-containing phosphoric acid. The etch rate represents the amount of decrease in film thickness per unit time.

"FIG. 4" is a broken line graph showing the relationships between the etch rates of the silicon oxide film and the silicon nitride film and the concentration of ammonium fluoride in the fluoride-containing phosphoric acid when the fluoride-containing phosphoric acid is at "120°C." "FIG. 5" is a broken line graph showing the relationships between the etch rates of the silicon oxide film and the silicon nitride film and the concentration of ammonium fluoride in the fluoride-containing phosphoric acid when the fluoride-containing phosphoric acid is at "130°C."

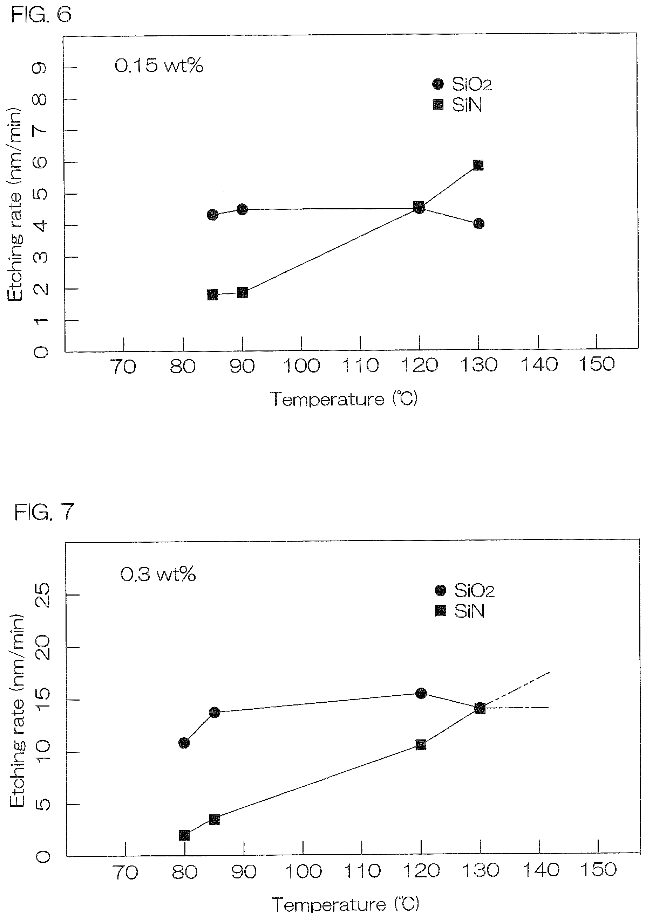

"FIG. 6" is a broken line graph showing the relationships between the etch rates of the silicon oxide film and the silicon nitride film and the temperature of the fluoride-containing phosphoric acid when the concentration of ammonium fluoride in the fluoride-containing phosphoric acid is "0.15 wt%." "FIG. 7" is a broken line graph showing the relationships between the etch rates of the silicon oxide film and the silicon nitride film and the temperature of the fluoride-containing phosphoric acid when the concentration of ammonium fluoride in the fluoride-containing phosphoric acid is "0.3 wt%." The alternate long and short dash line in FIG. 7 indicates a prediction of change in the etch rate of the silicon oxide film and the alternate long and two short dashed line in FIG. 7 indicates a prediction of change in the etch rate of the silicon nitride film.

As shown in FIG. 4, when the fluoride-containing phosphoric acid is at 120°C, the etch rate of the silicon oxide film and the etch rate of the silicon nitride film increased with increase in the concentration of the ammonium fluoride. A difference between the etch rate of the silicon oxide film and the etch rate of the silicon nitride film was smaller in a range in which the concentration of ammonium fluoride is not greater than 0.15 wt% than in a range of exceeding 0.15 wt%. In the range in which the concentration of ammonium fluoride exceeds 0.15 wt%, the etch rate of the silicon oxide film was greater than the etch rate of the silicon nitride film and the difference between the two spread with increase in the concentration of ammonium fluoride.

As shown in FIG. 5, when the fluoride-containing phosphoric acid is at 130°C, the etch rate of the silicon oxide film and the etch rate of the silicon nitride film increased with increase in the concentration of the ammonium fluoride. The etch rate of the silicon oxide film was less than the etch rate of the silicon nitride film in the range in which the concentration of ammonium fluoride is not greater than 0.15 wt%. The difference between the etch rate of the silicon oxide film and the etch rate of the silicon nitride film was smaller in a range in which the concentration of ammonium fluoride is not greater than 0.3 wt% than in a range of exceeding 0.3 wt%. In the range in which the concentration of ammonium fluoride exceeds 0.3 wt%, the etch rate of the silicon oxide film was greater than the etch rate of the silicon nitride film and the difference between the two spread with increase in the concentration of ammonium fluoride.

As shown in FIG. 6, when the concentration of ammonium fluoride is 0.15 wt%, the etch rate of the silicon oxide film was substantially constant in a range in which the temperature of the fluoride-containing phosphoric acid is less than 120°C and decreased with increase in temperature in a range in which the temperature of the fluoride-containing phosphoric acid is not less than 120°C. The etch rate of the silicon nitride film was substantially constant in a range in which the temperature of the fluoride-containing phosphoric acid is less than 90°C and increased with increase in temperature in a range in which the temperature of the fluoride-containing phosphoric acid is not less than 90°C.

As shown in FIG. 6, the etch rate of the silicon oxide film was greater than the etch rate of the silicon nitride film in the range in which the temperature of the fluoride-containing phosphoric acid is less than 120°C and the etch rate of the silicon oxide film was less than the etch rate of the silicon nitride film in a range in which the temperature of the fluoride-containing phosphoric acid exceeds 120°C. The difference between the etch rate of the silicon oxide film and the etch rate of the silicon nitride film decreased as the temperature of the fluoride-containing phosphoric acid approached 120°C.

As shown in FIG. 7, when the concentration of ammonium fluoride is 0.3 wt%, the etch rate of the silicon oxide film increased with increase in temperature in the range in which the temperature of the fluoride-containing phosphoric acid is less than 120°C and decreased with increase in temperature in a range in which the temperature of the fluoride-containing phosphoric acid is not less than 120°C and not more than 130°C. The etch rate of the silicon nitride film increased with increase in temperature in a range in which the temperature of the fluoride-containing phosphoric acid is not less than 80°C and not more than 130°C. According to the measurement results shown in FIG. 6, in a range in which the temperature of the fluoride-containing phosphoric acid exceeds 130°C, the etch rate of the silicon oxide film (see alternate long and short dash line in FIG. 7) is predicted to be substantially constant and the etch rate of the silicon nitride film (see alternate long and two short dashed line in FIG. 7) is predicted to increase with increase in temperature.

As shown in FIG. 7, the etch rate of the silicon oxide film was greater than the etch rate of the silicon nitride film in a range in which the temperature of the fluoride-containing phosphoric acid is less than 130°C. It is predicted that the etch rate of the silicon oxide film is less than the etch rate of the silicon nitride film in the range in which the temperature of the fluoride-containing phosphoric acid exceeds 130°C. The difference between the etch rate of the silicon oxide film and the etch rate of the silicon nitride film decreased as the temperature of the fluoride-containing phosphoric acid approached 130°C.

The temperature of the fluoride-containing phosphoric acid at which the broken line indicating the etch rate of the silicon oxide film and the broken line indicating the etch rate of the silicon nitride film intersect in each of FIG. 6 and FIG. 7 is defined as an isokinetic temperature. When the concentration of the phosphoric acid in the fluoride-containing phosphoric acid and the concentration of the fluoride in the fluoride-containing phosphoric acid are determined, a single isokinetic temperature is determined. That is, the isokinetic temperature depends on the concentration of the fluoride in the fluoride-containing phosphoric acid and refers to the temperature of the fluoride-containing phosphoric acid at which the etch rate of the silicon oxide film and the etch rate of the silicon nitride film at that concentration become equal. Oppositely, when the concentration of the phosphoric acid in the fluoride-containing phosphoric acid and the temperature of the fluoride-containing phosphoric acid are determined, a single fluoride isokinetic concentration is determined. The fluoride isokinetic concentration is the concentration of the fluoride at which the etch rate of the silicon oxide film and the etch rate of the silicon nitride film are equal.

From the results shown in FIG. 4 and FIG. 5, it can be understood that when the fluoride is added to the phosphoric acid, the etch rate of the silicon oxide film and the etch rate of the silicon nitride film increase. In addition, from the results shown in FIG. 4 and FIG. 5, it can be understood that when the temperature of the fluoride-containing phosphoric acid is constant, the etch rate of the silicon oxide film and the etch rate of the silicon nitride film increase with increase in the concentration of the fluoride. As can be understood from the results shown in FIG. 4 and FIG. 5, when the concentration of the fluoride in the fluoride-containing phosphoric acid exceeds a certain value (0.15 wt% in FIG. 4 and 0.3 wt% in FIG. 5), the etch rate of the silicon oxide film increases with increase in the concentration of the fluoride in the fluoride-containing phosphoric acid at a greater proportion than the etch rate of the silicon nitride film.

From the results shown in FIG. 6 and FIG. 7, it can be understood that the etch rate of the silicon oxide film does not change greatly even when the temperature of the fluoride-containing phosphoric acid changes and the etch rate of the silicon nitride film increases in accordance with increase in the temperature of the fluoride-containing phosphoric acid. In addition, from the results shown in FIG. 6 and FIG. 7, it can be understood that if the concentration of the fluoride in the fluoride-containing phosphoric acid is constant, there is present a single isokinetic temperature (the temperature of the intersection of the broken line indicating the etch rate of the silicon oxide film and the broken line indicating the etch rate of the silicon nitride film in each of FIG. 6 and FIG. 7) at which the etch rate of the silicon oxide film and the etch rate of the silicon nitride film are equal. As can be understood from the results shown in FIG. 6 and FIG. 7, when the concentration of the fluoride in the fluoride-containing phosphoric acid increases, the isokinetic temperature also increases.

From the results shown in FIG. 4 to FIG. 7, it can be understood that by maintaining the fluoride-containing phosphoric acid at the isokinetic temperature or a vicinity thereof while stabilizing the concentration of the phosphoric acid in the fluoride-containing phosphoric acid and the concentration of the fluoride in the fluoride-containing phosphoric acid, the silicon oxide film and the silicon nitride film can be etched at equal or substantially equal etch rates. When the concentration of the fluoride in the fluoride-containing phosphoric acid is increased, the etch rate of the silicon oxide film increases and the etch rate of the silicon nitride film corresponding to the isokinetic temperature also increases. Therefore, in addition to the conditions above, by maintaining the concentration of the fluoride in the fluoride-containing phosphoric acid at as large a value as possible, the silicon oxide film and the silicon nitride film can be etched at equal or substantially equal large etch rates.

In the etching of the bottom side portion 105b of the inner circumferential surface 105 of the memory hole 104 described above (see FIG. 1G), the fluoride-containing phosphoric acid of a constant etching temperature matching or approaching the isokinetic temperature is supplied to the substrate W. Thereby, the silicon oxide films and the silicon nitride films constituting the bottom side portion 105b of the inner circumferential surface 105 of the memory hole 104 can be etched equal or substantially equal large etch rates. The etching temperature may be set such that a selectivity (etch rate of the silicon nitride film/etch rate of the silicon oxide film) is 0.9 to 1.1 and the etch rate of the silicon oxide film and the etch rate of the silicon nitride film are 3 to 14 nm/min or may be set such that at least one among the selectivity, the etch rate of the silicon oxide film, and the etch rate of the silicon nitride film is of a value outside the above ranges.

Although a case of etching the silicon oxide film and the silicon nitride film with the fluoride-containing phosphoric acid that contains ammonium fluoride has been described thus far, the fluoride contained in the fluoride-containing phosphoric acid may instead be a fluoride other than ammonium fluoride such as ammonium bifluoride. When ammonium bifluoride is dissolved in water, it decomposes into ammonium fluoride and hydrogen fluoride as indicated by "NH₄HF₂ ⇔ NH₄F + HF." The fluoride-containing phosphoric acid that contains ammonium bifluoride is therefore considered to have characteristics similar to the fluoride-containing phosphoric acid that contains ammonium fluoride.

Next, the substrate processing apparatus 1 that supplies the fluoride-containing phosphoric acid to the substrate W shall be described. First, the substrate processing apparatus 1 of the batch type shall be described and then the substrate processing apparatus 1 of the single substrate processing type shall be described.

FIG. 8 is a schematic plan view showing a layout of the batch type substrate processing apparatus 1 according to an embodiment of the present invention.

The substrate processing apparatus 1 is a batch type apparatus that processes a plurality of substrates W in a batch. The substrate processing apparatus 1 includes load ports LP that hold carriers C housing disc-shaped substrates W such as semiconductor wafers, processing units 2 that process the substrates W transferred from the load ports LP with a processing liquid such as a chemical liquid and a rinse liquid, a transfer system that transfers the substrates W between the load ports LP and the processing units 2, and a controller 3 that controls the substrate processing apparatus 1.

The controller 3 is a computer that includes a memory that stores information such as a program, and a CPU (central processing unit) that controls the substrate processing apparatus 1 in accordance with the program stored in the memory. The controller 3 perform transfer and processing, etc., of the substrates W described below by controlling the substrate processing apparatus 1. In other words, the controller 3 is programmed to perform the transfer and the processing, etc., of the substrates W described below.

The processing unit 2 includes a plurality of pairs of liquid processing baths 4 that each store a processing liquid in which a plurality of substrates W are immersed and a dry processing bath 8 that dries the plurality of substrates W by a drying method such as decompression drying, etc. Decompression drying is a drying method with which a liquid attached to the substrate W is evaporated by reducing air pressure. The plurality of pairs of liquid processing baths 4 are aligned rectilinearly in a depth direction (right-left direction of the sheet of FIG. 8) of the substrate processing apparatus 1 in plan view. The dry processing bath 8 is disposed between the transfer system and the plurality of pairs of liquid processing baths 4 in the depth direction of the substrate processing apparatus 1 in plan view.

The transfer system includes a carrier transfer apparatus 9 that transfers the carriers C between the load ports LP and the processing units 2 and houses a plurality of the carriers C and an orientation converting robot 10 that performs carry-in and carry-out of a plurality of substrates W with respect to the carriers C held by the carrier transfer apparatus 9 and changes orientations of the substrates W between a horizontal orientation and a vertical orientation. The orientation converting robot 10 performs a batching operation of forming a single batch with the plurality of substrates W taken out from the plurality of carriers C and an unbatching operation of housing, in the plurality of carriers C, the plurality of substrates W that are included in the single batch.

The transfer system further includes a main transfer robot 11 that transfers the plurality of substrates W between the orientation converting robot 10 and the processing units 2 and a plurality of auxiliary transfer robots 12 that transfer the plurality of substrates W between the main transfer robot 11 and the processing units 2. FIG. 8 shows an example where two auxiliary transfer robots 12 and two pairs of liquid processing baths 4 are provided. The auxiliary transfer robot 12 performs carry-in and carry-out of a plurality of substrates W with respect to each of the pair of liquid processing baths 4 and transfers the plurality of substrates W between the pair of liquid processing baths 4.

The main transfer robot 11 receives the single batch of substrates W that consists of the plurality (for example, 50) of substrates W from the orientation converting robot 10 and transfers the received single batch of substrates W to one of the plurality of auxiliary transfer robots 12. The auxiliary transfer robot 12 immerses the single batch of substrates W received from the main transfer robot 11 in the processing liquid in at least one of the liquid processing baths 4. Thereafter, the main transfer robot 11 receives the single batch of substrates W from the auxiliary transfer robot 12 and transfers the received single batch of substrates W to the dry processing baths 8.

The plurality of liquid processing baths 4 include a heat processing bath 5 that stores a heating liquid in which the plurality of substrates W are immersed, a chemical liquid processing bath 6 that stores a chemical liquid in which the plurality of substrates W are immersed, and a rinse processing bath 7 that stores a rinse liquid in which the plurality of substrates W are immersed. The heat processing bath 5, the chemical liquid processing bath 6, and the rinse processing bath 7 are aligned rectilinearly in that order in the depth direction of the substrate processing apparatus 1 in plan view. The dry processing bath 8 is disposed between the transfer system and the rinse processing bath 7 in the depth direction of the substrate processing apparatus 1 in plan view.

The heating liquid is the phosphoric acid and the chemical liquid is the fluoride-containing phosphoric acid. The rinse liquid is pure water. The heating liquid may be a liquid other than phosphoric acid such as pure water, etc. Similarly, the rinse liquid may be a liquid other than pure water. For example, the rinse liquid may be any of IPA (isopropyl alcohol), electrolyzed ion water, hydrogen water, ozone water, aqueous hydrochloric acid solution of dilute concentration (for example, approximately 10 to 100ppm), and ammonia water of dilute concentration (for example, approximately 10 to 100ppm).

The substrates W with each of which the silicon oxide films O1 and the silicon nitride films N1 are exposed as shown in FIG. 1F are transferred to the substrate processing apparatus 1. The transfer system transfers the substrates W of a single batch to the heat processing bath 5, the chemical liquid processing bath 6, the rinse processing bath 7, and the dry processing bath 8 successively in that order. Therefore, the substrates W carried into the substrate processing apparatus 1 through the load ports LP are brought into contact with the sulfuric acid, the fluoride-containing phosphoric acid, and the pure water successively in that order and dried. By supplying the fluoride-containing phosphoric acid to each substrate W, the bottom side portion 105b of the inner circumferential surface 105 of the memory hole 104 is etched as shown in FIG. 1G. The fluoride-containing phosphoric acid attached to the substrate W is rinsed off by the pure water. The substrate W that is wet with pure water is dried in the dry processing bath 8. The dried substrates W are carried out of the substrate processing apparatus 1 through the load ports LP.

The phosphoric acid inside the heat processing bath 5 and the fluoride-containing phosphoric acid inside the chemical liquid processing bath 6 are maintained at a constant temperature of not less than 100°C. The pure water in the rinse processing bath 7 may be at room temperature (a constant or substantially constant temperature within 15 to 30°C) or may be maintained at a constant temperature higher or lower than room temperature. The temperature of the phosphoric acid is, for example, within a range of 100 to 150°C and the temperature of the fluoride-containing phosphoric acid is, for example, within a range of 100 to 150°C. The temperature of the phosphoric acid may be equal to the temperature of the fluoride-containing phosphoric acid or may be higher or lower than the temperature of the fluoride-containing phosphoric acid. Since the substrates W are heated by the phosphoric acid inside the heat processing bath 5, the substrates W of the same or substantially the same temperature as the phosphoric acid in the heat processing bath 5 are transferred into the chemical liquid processing bath 6.

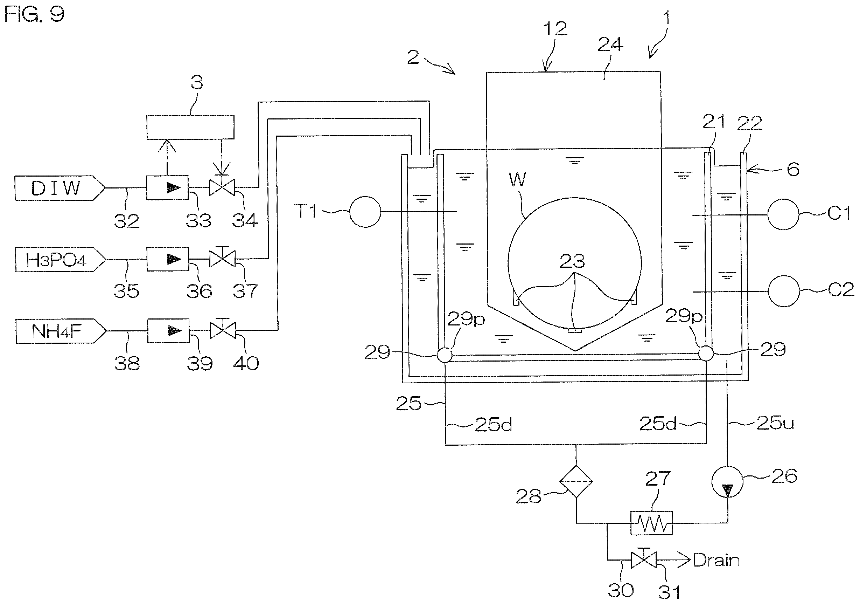

If the heating liquid is the phosphoric acid, the silicon oxide films O1 and the silicon nitride films N1 become etched, although slightly, when the silicon oxide films O1 and the silicon nitride films N1 are brought into contact with the heating liquid. If such etching is unfavorable, a liquid such as pure water, etc., that does not etch the silicon oxide films O1 and the silicon nitride films N1 should be used as the heating liquid. If the heating liquid is the phosphoric acid, a phosphoric acid piping 35 (see FIG. 9) for the fluoride-containing phosphoric acid may be used as a piping for the heating liquid.

FIG. 9 is a schematic view showing an example of a vertical cross section of the chemical liquid processing bath 6. Although not illustrated, the heat processing bath 5 and the rinse processing bath 7 have the same arrangement as the chemical liquid processing bath 6.

The chemical liquid processing bath 6 includes an inner bath 21 storing the fluoride-containing phosphoric acid and an outer bath 22 storing the fluoride-containing phosphoric acid that overflowed from the inner bath 21. The plurality of substrates W are placed inside the inner bath 21 and immersed in the fluoride-containing phosphoric acid inside the inner bath 21. Thereby, the fluoride-containing phosphoric acid is brought into contact with the plurality of substrates W and the plurality of substrates W are etched.

Each auxiliary transfer robot 12 includes a plurality of holders 23 that hold the plurality of substrates W in a vertical orientation and a lifter 24 that raises and lowers the plurality of holders 23 vertically between an upper position at which the plurality of substrates W held by the holders 23 are separated upward from the fluoride-containing phosphoric acid inside the inner bath 21 and a lower position (position shown in FIG. 9) at which the plurality of substrates W held by the holders 23 are immersed in the fluoride-containing phosphoric acid inside the inner bath 21. The plurality of substrates W held by the holders 23 enter inside the inner bath 21 through an opening portion provided at an upper end portion of the inner bath 21 and exits out of the inner bath 21 through the opening portion of the inner bath 21.

The substrate processing apparatus 1 includes a circulation heating system that heats while circulating the fluoride-containing phosphoric acid inside the chemical liquid processing bath 6. The circulation heating system includes a circulation piping 25 that guides the fluoride-containing phosphoric acid inside the outer bath 22 toward the inner bath 21, a circulation pump 26 that feeds the fluoride-containing phosphoric acid inside the circulation piping 25 toward the inner bath 21, a heater 27 that heats the fluoride-containing phosphoric acid flowing inside the circulation piping 25 at a temperature higher than room temperature, and a filter 28 that removes foreign matter from the fluoride-containing phosphoric acid flowing inside the circulation piping 25.

The circulation heating system further includes chemical liquid nozzles 29 by each of which the fluoride-containing phosphoric acid supplied from the circulation piping 25 is discharged from a discharge port 29p disposed inside the inner bath 21 to supply the fluoride-containing phosphoric acid into the inner bath 21 and form an upward flow inside the fluoride-containing phosphoric acid inside the inner bath 21. FIG. 9 shows an example where two chemical liquid nozzles 29 are provided. In this example, the circulation piping 25 includes an upstream piping 25u that extends downstream from the outer bath 22 and two downstream pipings 25d that branch from the upstream piping 25u. One chemical liquid nozzle 29 is mounted to a downstream end of one downstream piping 25d and the other chemical liquid nozzle 29 is mounted to a downstream of the other downstream piping 25d.

The inner bath 21, the outer bath 22, the circulation piping 25, and the chemical liquid nozzles 29 form a circulation path that circulates the fluoride-containing phosphoric acid. An amount of the fluoride-containing phosphoric acid inside the chemical liquid processing bath 6 is greater than a volume of the inner bath 21 (a maximum amount of the fluoride-containing phosphoric acid that the inner bath 21 can store). The circulation pump 26 constantly feeds the fluoride-containing phosphoric acid from an upstream end of the circulation piping 25 to a downstream end of the circulation piping 25. The fluoride-containing phosphoric acid thus continues to overflow from the inner bath 21 to the outer bath 22 and circulates through the circulation path. While circulating through the circulation path, the fluoride-containing phosphoric acid is heated by the heater 27 and is maintained at the constant temperature higher than room temperature.

The circulation heating system includes a drain piping 30 that guides the fluoride-containing phosphoric acid drained from the circulation piping 25 and a drain valve 31 that is switched between an open state in which the fluoride-containing phosphoric acid is drained from the circulation piping 25 to the drain piping 30 and a closed state in which the fluoride-containing phosphoric acid is not drained from the circulation piping 25 to the drain piping 30. The drain piping 30 is connected to the circulation piping 25 at a downstream of the circulation pump 26. When the drain valve 31 is opened, the fluoride-containing phosphoric acid inside the circulation piping 25 flows into the drain piping 30 and is drained from the circulation piping 25.

The substrate processing apparatus 1 includes a supply system that supplies the fluoride-containing phosphoric acid to the chemical liquid processing bath 6. The supply system includes a pure water piping 32 that guides the pure water from a pure water supply source to the chemical liquid processing bath 6, a phosphoric acid piping 35 that supplies the phosphoric acid from a phosphoric acid supply source to the chemical liquid processing bath 6, and a fluoride piping 38 that guides a fluoride-containing liquid from a fluoride supply source to the chemical liquid processing bath 6. The fluoride-containing liquid is a liquid of the fluoride or a solution in which the fluoride is dissolved. A concentration of the fluoride in the fluoride-containing liquid is higher than the concentration of the fluoride in the fluoride-containing phosphoric acid.

The supply system includes a pure water valve 34 mounted to the pure water piping 32, a phosphoric acid valve 37 mounted to the phosphoric acid piping 35, and a fluoride valve 40 mounted to the fluoride piping 38. The phosphoric acid valve 37 is switched between an open state in which the phosphoric acid inside the phosphoric acid piping 35 is supplied to the chemical liquid processing bath 6 and a closed state in which the phosphoric acid inside the phosphoric acid piping 35 is not supplied to the chemical liquid processing bath 6. The same applies to the pure water valve 34 and the fluoride valve 40.

Although not shown, the phosphoric acid valve 37 includes a valve body provided with an internal flow passage through which a fluid flows and an annular valve seat forming a portion of the internal flow passage, a valve element that is movable with respect to the valve seat, and an actuator that moves the valve element between a closed position at which the valve element contacts the valve seat and an open position at which the valve element is separated from the valve seat. The same applies to other valves. The actuator may be a pneumatic actuator or an electric actuator or may be an actuator other than these. The controller 3 opens and closes the phosphoric acid valve 37 by controlling the actuator.

When the controller 3 opens, that is, switches the phosphoric acid valve 37 from the closed state to the open state, the phosphoric acid inside the phosphoric acid piping 35 is supplied to the chemical liquid processing bath 6. Similarly, when the controller 3 opens the pure water valve 34, the pure water inside the pure water piping 32 is supplied to the chemical liquid processing bath 6 and when the controller 3 opens the fluoride valve 40, the fluoride-containing liquid inside the fluoride piping 38 is supplied to the chemical liquid processing bath 6. The phosphoric acid, the pure water, and the fluoride-containing liquid are supplied to at least one of the inner bath 21 and the outer bath 22. FIG. 9 shows an example in which the phosphoric acid, etc., are supplied to the outer bath 22.

When the pure water or the fluoride-containing liquid is supplied from the pure water piping 32 or the fluoride piping 38 to the chemical liquid processing bath 6, the concentration of the phosphoric acid in the fluoride-containing phosphoric acid decreases in accordance with a supply amount of the pure water or the fluoride-containing liquid. When the phosphoric acid is supplied from the phosphoric acid piping 35 to the chemical liquid processing bath 6, the concentration of the phosphoric acid in the fluoride-containing phosphoric acid increases in accordance with a supply amount of the phosphoric acid.

Similarly, when the phosphoric acid or the pure water is supplied from the phosphoric acid piping 35 or the pure water piping 32 to the chemical liquid processing bath 6, the concentration of the fluoride in the fluoride-containing phosphoric acid decreases in accordance with the supply amount of the phosphoric acid or the pure water. When the fluoride-containing liquid is supplied from the fluoride piping 38 to the chemical liquid processing bath 6, the concentration of the fluoride in the fluoride-containing phosphoric acid increases in accordance with the supply amount of the fluoride-containing liquid.

The controller 3 is electrically connected to a pure water flowmeter 33 that measures a flow rate of the pure water supplied from the pure water piping 32 to the chemical liquid processing bath 6. Similarly, the controller 3 is electrically connected to a phosphoric acid flowmeter 36 that measures a flow rate of the phosphoric acid supplied from the phosphoric acid piping 35 to the chemical liquid processing bath 6 and is electrically connected to a fluoride flowmeter 39 that measures a flow rate of the fluoride-containing liquid supplied from the fluoride piping 38 to the chemical liquid processing bath 6.

The controller 3 detects the amount of the pure water supplied to the chemical liquid processing bath 6 based on a measurement value of the pure water flowmeter 33. Similarly, the controller 3 detects the amount of the phosphoric acid supplied to the chemical liquid processing bath 6 based on a measurement value of the phosphoric acid flowmeter 36 and detects the amount of fluoride-containing liquid supplied to the chemical liquid processing bath 6 based on a measurement value of the fluoride flowmeter 39. The concentration of the phosphoric acid in the fluoride-containing phosphoric acid and the concentration of the fluoride in the fluoride-containing phosphoric acid change in accordance with the amount and type of liquid supplied to the chemical liquid processing bath 6

The controller 3 is electrically connected to a phosphoric acid concentration meter C1 that measures the concentration of the phosphoric acid in the fluoride-containing phosphoric acid and a fluoride concentration meter C2 that measures the concentration of the fluoride in the fluoride-containing phosphoric acid. The controller 3 is further electrically connected to a thermometer T1 that detects the temperature of the fluoride-containing phosphoric acid. FIG. 9 shows an example where the phosphoric acid concentration meter C1 and the fluoride concentration meter C2 measure the concentrations in the fluoride-containing phosphoric acid inside the inner bath 21 and the thermometer T1 measures the temperature of the fluoride-containing phosphoric acid inside the inner bath 21. The phosphoric acid concentration meter C1 may instead measure the concentration in the fluoride-containing phosphoric acid inside the outer bath 22 or measure the concentration in the fluoride-containing phosphoric acid inside the circulation piping 25. The same applies to the fluoride concentration meter C2 and the thermometer T1.

The controller 3 detects the concentration of the phosphoric acid in the fluoride-containing phosphoric acid based on a measurement value of the phosphoric acid concentration meter C1. If the detected concentration of the phosphoric acid differs from a phosphoric acid setting concentration, the controller 3 supplies at least one among the phosphoric acid, the pure water, and the fluoride-containing liquid to the chemical liquid processing bath 6 to make the concentration of the phosphoric acid in the fluoride-containing phosphoric acid approach the phosphoric acid setting concentration. The concentration of the phosphoric acid in the fluoride-containing phosphoric acid can thereby be maintained at the phosphoric acid setting concentration.

Similarly, the controller 3 detects the concentration of the fluoride in the fluoride-containing phosphoric acid based on a measurement value of the fluoride concentration meter C2. If the detected concentration of the fluoride differs from a fluoride setting concentration, the controller 3 supplies at least one among the phosphoric acid, the pure water, and the fluoride-containing liquid to the chemical liquid processing bath 6 to make the concentration of the fluoride in the fluoride-containing phosphoric acid approach the fluoride setting concentration. The concentration of the fluoride in the fluoride-containing phosphoric acid can thereby be maintained at the fluoride setting concentration.

The controller 3 also detects the temperature of the fluoride-containing phosphoric acid based on a measurement value of the thermometer T1. If the detected temperature of the fluoride-containing phosphoric acid is higher than the etching temperature, the controller 3 makes a temperature of the heater 27 decrease. If the detected temperature of the fluoride-containing phosphoric acid is lower than the etching temperature, the controller 3 makes a temperature of the heater 27 increase. The temperature of the fluoride-containing phosphoric acid can thereby be increased or decreased and maintained at the etching temperature.

The "phosphoric acid setting concentration" represents a setting value of the concentration of the phosphoric acid in the fluoride-containing phosphoric acid to be supplied to the substrates W. The "fluoride setting concentration" represents a setting value of the concentration of the fluoride in the fluoride-containing phosphoric acid to be supplied to the substrates W. The "etching temperature" represents a setting value of the temperature of the fluoride-containing phosphoric acid to be supplied to the substrates W. The phosphoric acid setting concentration, the fluoride setting concentration, and the etching temperature may be input directly or indirectly into the substrate processing apparatus 1 by a user or may be stored in the controller 3.

If the phosphoric acid setting concentration, the fluoride setting concentration, and the etching temperature are stored in the controller 3, the phosphoric acid setting concentration, etc., may be designated by a recipe stored in the controller 3. The recipe is information specifying processing contents, processing conditions, and processing procedures of the substrates W. The controller 3 stores a plurality of recipes. The plurality of recipes differ from each other in at least one among the processing contents, processing conditions, and processing procedures of the substrates W. The controller 3 controls the substrate processing apparatus 1 such that the substrates W are processed in accordance with the recipe designated by a host computer.

The phosphoric acid setting concentration, the fluoride setting concentration, and the etching temperature are set such that the etch rate of the silicon oxide films O1 and the etch rate of the silicon nitride films N1 become equal or substantially equal. In other words, the phosphoric acid setting concentration, the fluoride setting concentration, and the etching temperature are set such that the selectivity becomes 1 or substantially 1. The silicon oxide films O1 and the silicon nitride films N1 brought into contact with the fluoride-containing phosphoric acid inside the chemical liquid processing bath 6 are thus etched at equal or substantially equal etch rates.

As can be understood from the results shown in FIG. 4 to FIG. 7, the selectivity decreases with increase in the concentration of the fluoride in the fluoride-containing phosphoric acid and increases or decreases as the temperature of the fluoride-containing phosphoric acid separates from the isokinetic temperature (the temperature at which the etch rate of the silicon oxide film and the etch rate of the silicon nitride film are equal). The phosphoric acid setting concentration, the fluoride setting concentration, and the etching temperature may be set such that the selectivity becomes a value different from 1 intentionally.

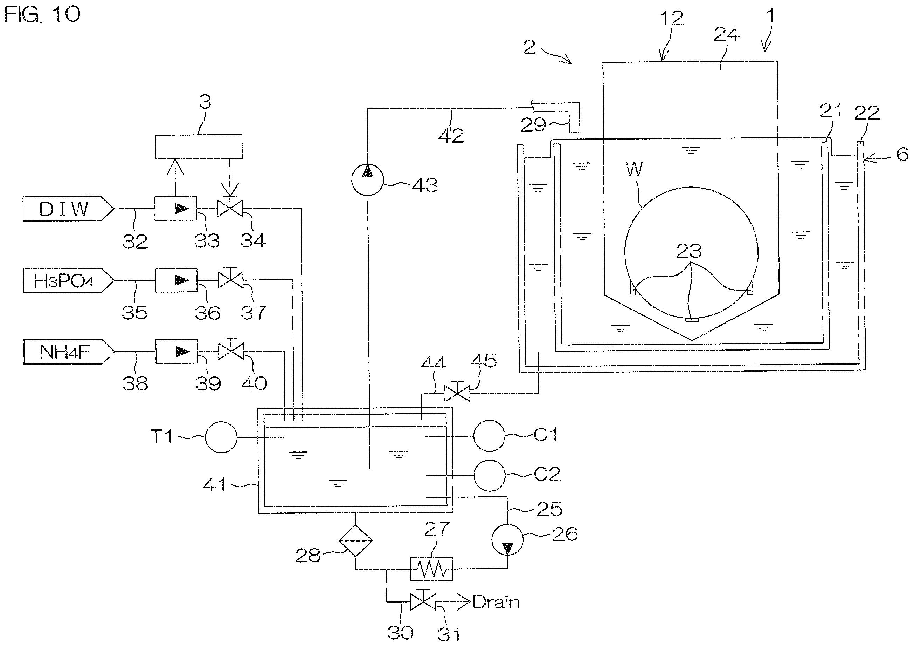

FIG. 10 is a schematic view showing another example of the vertical cross section of the chemical liquid processing bath 6.

A point by which the chemical liquid processing bath 6 shown in FIG. 10 mainly differs from the chemical liquid processing bath 6 shown in FIG. 9 is that a mixing tank 41 for mixing the phosphoric acid, the pure water, and the fluoride-containing liquid is provided.

The supply system supplying the fluoride-containing phosphoric acid to the chemical liquid processing bath 6 includes the mixing tank 41 that stores the fluoride-containing phosphoric acid to be supplied to the chemical liquid processing bath 6, a supply piping 42 that guides the fluoride-containing phosphoric acid from the mixing tank 41 to the chemical liquid processing bath 6, and a supply pump 43 that feeds the fluoride-containing phosphoric acid from the mixing tank 41 to the chemical liquid processing bath 6 through the supply piping 42. The supply system further includes a recovery piping 44 that guides the fluoride-containing phosphoric acid from the chemical liquid processing bath 6 to the mixing tank 41 and a recovery valve 45 that switches between an open state in which the fluoride-containing phosphoric acid flows from the recovery piping 44 to the mixing tank 41 and a closed state in which the fluoride-containing phosphoric acid does not flow from the recovery piping 44 to the mixing tank 41.

The supply piping 42 guides the fluoride-containing phosphoric acid from the mixing tank 41 to the inner bath 21 and the recovery piping 44 guides the fluoride-containing phosphoric acid from the outer bath 22 to the mixing tank 41. The chemical liquid nozzle 29 discharges the fluoride-containing phosphoric acid, guided by the supply piping 42, toward the inner bath 21. The chemical liquid nozzle 29 may discharge the fluoride-containing phosphoric acid toward both the inner bath 21 and the outer bath 22. The mixing tank 41, the supply piping 42, the chemical liquid nozzle 29, the inner bath 21, the outer bath 22, and the recovery piping 44 form a circulation path that circulates the fluoride-containing phosphoric acid. The supply pump 43 constantly feeds the fluoride-containing phosphoric acid from an upstream end of the supply piping 42 to a downstream end of the supply piping 42.

The upstream end and the downstream end of the circulation piping 25 are connected not to the inner bath 21 and the outer bath 22 but to the mixing tank 41. The mixing tank 41 and the circulation piping 25 form a circulation path independent of the chemical liquid processing bath 6, that is, not passing through the chemical liquid processing bath 6. The phosphoric acid piping 35, the pure water piping 32, and the fluoride piping 38 are connected to the mixing tank 41. The phosphoric acid, the pure water, and the fluoride-containing liquid supplied to the mixing tank 41 from the phosphoric acid piping 35, the pure water piping 32, and the fluoride piping 38 are mixed inside the mixing tank 41 and supplied to the chemical liquid processing bath 6 via the supply piping 42 and the chemical liquid nozzle 29. The phosphoric acid concentration meter C1, the fluoride concentration meter C2, and the thermometer T1 measure the concentrations in or the temperature of the fluoride-containing phosphoric acid inside the mixing tank 41.

The controller 3 maintains the concentration of the phosphoric acid in the fluoride-containing phosphoric acid inside the mixing tank 41 at the phosphoric acid setting concentration and maintains the concentration of the fluoride in the fluoride-containing phosphoric acid inside the mixing tank 41 at the fluoride setting concentration. The controller 3 further maintains the temperature of the fluoride-containing phosphoric acid inside mixing tank 41 at the etching temperature. Thereby, the fluoride-containing phosphoric acid with which the concentration of the phosphoric acid, the concentration of the fluoride, and the temperature of the fluoride-containing phosphoric acid match or substantially match the phosphoric acid setting concentration, the fluoride setting concentration, and the etching temperature can be supplied from the mixing tank 41 to the chemical liquid processing bath 6 and the plurality of substrates W inside the inner bath 21 can be etched with this fluoride-containing phosphoric acid.

Next, the single substrate processing type substrate processing apparatus 1 shall be described.

FIG. 11A is a schematic plan view showing a layout of the single substrate processing type substrate processing apparatus 1 according to an embodiment of the present invention. FIG. 11B is a schematic side view of the single substrate processing type substrate processing apparatus 1.

As shown in FIG. 11A, the substrate processing apparatus 1 is a single substrate processing type apparatus that processes disc-shaped substrates W such as semiconductor wafers one by one. The substrate processing apparatus 1 includes load ports LP that hold carriers C housing substrates W, a plurality of processing units 2 that process the substrates W transferred from the carriers C on the load ports LP, a transfer system that transfers the substrates W between the carriers C on the load ports LP and the plurality of processing units 2, and a controller 3 that controls the substrate processing apparatus 1.

The transfer system includes an indexer robot IR that carries the substrates W into and out from the carrier C on the load port LP and a center robot CR that carries the substrates W into and out from each of the processing units 2. The indexer robot IR transfers the substrates W between the load port LP and the center robot CR, the center robot CR transfers the substrates W between the indexer robot IR and the processing units 2. The center robot CR includes a hand H1 that supports the substrate W and the indexer robot IR includes a hand H2 that supports the substrate W.

The plurality of processing units 2 form a plurality of towers TW disposed around the center robot CR in a plan view. FIG. 11A shows an example in which four towers TW are formed. The center robot CR is able to access any one of the towers TW. As shown in FIG. 11B, each tower TW includes a plurality of processing units 2 (for example, three processing units 2) stacked vertically.

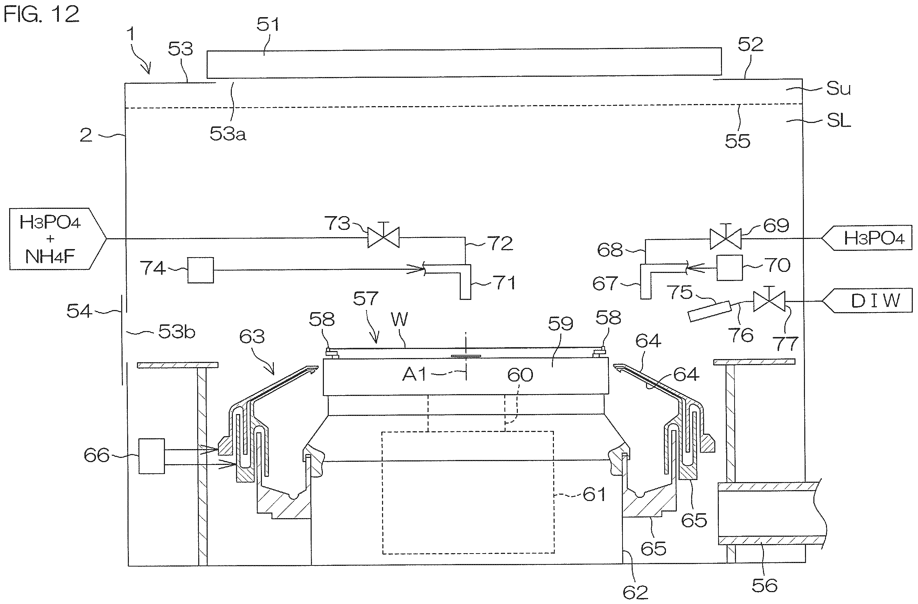

FIG. 12 is a schematic view of an interior of the processing unit 2 when viewed horizontally.

The processing unit 2 includes a box-shaped chamber 52 having an internal space, a spin chuck 57 (a substrate holder) that rotates the substrate W around a vertical rotation axis A1 passing through the central portion of the substrate W while holding the substrate W horizontally within the chamber 52, a plurality of nozzles that discharge a processing fluid such as a processing liquid and a processing gas toward the substrate W held by the spin chuck 57 and a cylindrical processing cup 63 that receives a processing liquid that has splashed outward from the spin chuck 57 and the substrate W.

The chamber 52 includes a box-shaped partition wall 53 provided with a carry-in/carry-out port 53b through which the substrate W transferred by the center robot CR (refer to FIG. 11A) passes, and a shutter 54 that opens and closes the carry-in/carry-out port 53b. An FFU 51 (fan filter unit 51) that sends clean air (air filtered by a filter) into the chamber 52 is disposed above the air outlet 53a that is open in the ceiling surface of the partition wall 53. The air outlet 53a is provided in an upper end portion of the chamber 52, and an exhaust duct 56 that expels gas from the chamber 52 is disposed in a lower end portion of the chamber 52.

The chamber 52 includes a rectifying plate 55 that partitions the internal space of the chamber 52 into an upper space Su and a lower space SL. The upper space Su between the ceiling surface of the partition wall 53 and the upper surface of the rectifying plate 55 is a diffusion space in which the clean air diffuses. The lower space SL between the lower surface of the rectifying plate 55 and the floor surface of the partition wall 53 is a processing space in which processing of the substrate W is performed. The spin chuck 57 is disposed in the lower space SL. The processing of the substrate W is performed in a state where the downward flow of the clean air is being formed in the lower space SL.

The spin chuck 57 includes a plurality of chuck pins 58 that clamp the substrate W horizontally and a disk-shaped spin base 59 that supports the plurality of chuck pins 58. The spin chuck 57 further includes a spin shaft 60 that extends downward from a central portion of the spin base 59, an electric motor 61 that rotates the spin shaft 60 to rotate the plurality of chuck pins 58 and the spin base 59, and a chuck housing 62 that surrounds the electric motor 61. The spin chuck 57 may be a chuck of other form such as a vacuum chuck, etc.

The processing cup 63 includes a plurality of guards 64 that receive processing liquids that have splashed outward from the spin chuck 57 and the substrate W, a plurality of cups 65 that receive processing liquids guided downward by the plurality of guards 64. FIG. 12 shows an example where two guards 64 and two cups 65 are provided and the cup 65 at an outermost side is integral to the second guard 64 from an outer side.

The plurality of guards 64 are connected to a guard raising/lowering unit 66 that individually raises and lowers the guards 64 in the vertical direction. The guard raising/lowering unit 66 locates the guard 64 in an arbitrary position within a range of from an upper position to a lower position. FIG. 12 shows a state where two guards 64 are disposed at the lower positions. The upper position is a position in which the upper end of the guard 64 is disposed above a holding position in which the substrate W held by the spin chuck 57 is disposed. The lower position is a position in which the upper end of the guard 64 is disposed below the holding position of the substrate W by the spin chuck 57. The holding position of the substrate W by the spin chuck 57 is a position in which the substrate W held by the spin chuck 57 is disposed.

When a processing liquid is supplied to the substrate W that is rotating, the controller 3 controls the guard raising/lowering unit 66 to position at least one of the guards 64 at the upper position. When the processing liquid is supplied to the substrate W in this state, the processing liquid is spun off outward from the substrate **W.** The spun-off processing liquid collides with the inner circumferential surface of the guard 64 that opposes the substrate W horizontally and is guided into the cup 65 corresponding to the guard 64. The processing liquid expelled from the substrate W is thereby collected in the cup 65.

The plurality of nozzles include a heating fluid nozzle 67 that discharges a heating liquid toward the upper surface of the substrate W held by the spin chuck 57, a chemical liquid nozzle 71 discharges a fluoride-containing phosphoric acid toward the upper surface of the substrate W held by the spin chuck 57, and a rinse liquid nozzle 75 discharges a rinse liquid toward the upper surface of the substrate W held by the spin chuck 57.

The chemical liquid nozzle 71 may be a scan nozzle that can move a collision position of the chemical liquid with respect to the substrate W within the upper surface of the substrate W or may be a fixed nozzle that cannot move the collision position of the chemical liquid with respect to the substrate **W.** The same applies to other nozzles. FIG. 12 shows an example where the chemical liquid nozzle 71 and the heating fluid nozzle 67 are scan nozzles and the rinse liquid nozzle 75 is a fixed nozzle.

In the example shown in FIG. 12, the heating fluid nozzle 67 is connected to a nozzle moving unit 70 and the chemical liquid nozzle 71 is connected to a nozzle moving unit 74. The nozzle moving unit 74 moves the chemical liquid nozzle 71 horizontally between a processing position at which the chemical liquid discharged from the chemical liquid nozzle 71 collides with the upper surface of the substrate W and a standby position at which the chemical liquid nozzle 71 is positioned at a periphery of the spin chuck 57 in plan view. The same applies to the nozzle moving unit 70.

The heating fluid nozzle 67 is connected to a heating liquid piping 68 guiding the phosphoric acid that is an example of the heating liquid from a heating liquid supply source to the heating fluid nozzle 67. When the controller 3 opens a heating liquid valve 69 mounted to the heating liquid piping 68, the heating fluid nozzle 67 discharges the phosphoric acid of a high temperature (for example, 100 to 150°C) and when the controller 3 closes the heating liquid valve 69, the heating fluid nozzle 67 stops the discharge of the phosphoric acid. The heating fluid may be a heating liquid other than the phosphoric acid or may be a heating gas such as nitrogen gas, etc.

The chemical liquid nozzle 71 is connected to a chemical liquid piping 72 guiding the fluoride-containing phosphoric acid that is an example of the chemical liquid from a chemical liquid supply source to the chemical liquid nozzle 71. When the controller 3 opens a chemical liquid valve 73 mounted to the chemical liquid piping 72, the chemical liquid nozzle 71 discharges the fluoride-containing phosphoric acid of a high temperature (for example, 100 to 150°C) and when the controller 3 closes the chemical liquid valve 73, the chemical liquid nozzle 71 stops the discharge of the fluoride-containing phosphoric acid.

The fluoride-containing phosphoric acid supplied to the chemical liquid nozzle 71 is, for example, the fluoride-containing phosphoric acid inside the mixing tank 41 shown in FIG. 10. Thereby, the fluoride-containing phosphoric acid with which the concentration of the phosphoric acid, the concentration of the fluoride, and the temperature match or substantially match the phosphoric acid setting concentration, the fluoride setting concentration, and the etching temperature can be discharged by the chemical liquid nozzle 71 and can be supplied to the substrate W held by the spin chuck 57.

To supply the fluoride-containing phosphoric acid inside the mixing tank 41 shown in FIG. 10 to the chemical liquid nozzle 71, the chemical liquid piping 72 may be connected directly to the mixing tank 41 or may be connected to the mixing tank 41 via the circulation piping 25. In the former case, the supply piping 42 shown in FIG. 10 may be used as the chemical liquid piping 72. More specifically, the chemical liquid nozzle 71 and the chemical liquid valve 73 may be mounted to the supply piping 42 as the chemical liquid piping 72. The fluoride-containing phosphoric acid collected in the cup 65 may be recovered in the mixing tank 41 via the recovery piping 44.

The rinse liquid nozzle 75 is connected to a rinse liquid piping 76 guiding the pure water that is an example of the rinse liquid from a rinse liquid supply source to the rinse liquid nozzle 75. When the controller 3 opens a rinse liquid valve 77 mounted to the rinse liquid piping 76, the rinse liquid nozzle 75 discharges the rinse liquid and when the controller 3 closes the rinse liquid valve 77, the rinse liquid nozzle 75 stops the discharge of the rinse liquid. The rinse liquid discharged from the rinse liquid nozzle 75 may be at room temperature or may be higher or lower than room temperature.

The substrate W with which the silicon oxide films O1 and the silicon nitride films N1 are exposed as shown in FIG. 1F is transferred to the substrate processing apparatus 1. The transfer system carries the single substrate W into the processing unit 2 from the carrier C on the load port LP. After the single substrate W that has been carried in is processed at the processing unit 2, the transfer system transfers the processed single substrate W from the processing unit 2 to the carrier C on the load port LP. Therefore, the substrate W carried into the substrate processing apparatus 1 through the load port LP is processed at the processing unit 2 and thereafter carried out from the substrate processing apparatus 1 through the load port LP.

After the single substrate W has been transferred to the spin chuck 57 by the center robot CR, the controller 3 makes the spin chuck 57 hold and rotate the substrate W. In this state, the controller 3 makes the heating fluid nozzle 67, the chemical liquid nozzle 71, and the rinse liquid nozzle 75 discharge the phosphoric acid, the fluoride-containing phosphoric acid, and the pure water successively in that order. The phosphoric acid, the fluoride-containing phosphoric acid, and the pure water are thereby supplied successively in that order to an entire range of the upper surface of the substrate W. Thereafter, the controller 3 dries the substrate W by making the spin chuck 57 rotate at a high speed. After the substrate W has been dried, the controller 3 stops the rotation of the spin chuck 57 and makes the spin chuck 57 release the holding of the substrate W. Thereafter, the controller 3 makes the center robot CR transfer the processed substrate W on the spin chuck 57.

As described above, with the present embodiment, the fluoride-containing phosphoric acid that is the phosphoric acid containing the fluoride is brought into contact with the silicon oxide films O1 and the silicon nitride films N1 formed on the substrate W to etch the silicon oxide films O1 and the silicon nitride films N1 with the fluoride-containing phosphoric acid. The fluoride-containing phosphoric acid is maintained at the etching temperature that matches or approaches the isokinetic temperature at which the etch rate of the silicon oxide films O1 and the etch rate of the silicon nitride films N1 at the concentration of the fluoride in the fluoride-containing phosphoric acid are equal to each other. The silicon oxide films O1 and the silicon nitride films N1 can thus be etched at equal or substantially equal etch rates.

With the present embodiment, the fluoride-containing phosphoric acid of the etching temperature containing the fluoride that increases the etch rate of the silicon oxide films O1 and the etch rate of the silicon nitride films N1 is brought into contact with the silicon oxide films O1 and the silicon nitride film N1 formed on the substrate W. Thereby, the silicon oxide films O1 can be etched at a greater etch rate than when the silicon oxide films O1 are etched with the phosphoric acid that does not contain the fluoride and the silicon nitride films N1 can be etched at a greater etch rate than when the silicon nitride films N1 are etched with the phosphoric acid that does not contain the fluoride. Consequently, a processing time of the substrate W can be shortened and consumption of energy, such as electric power, etc., can be reduced.

With the present embodiment, the fluoride-containing phosphoric acid that changes in selectivity in accordance with temperature is maintained at the isokinetic temperature or a temperature in a vicinity thereof and the fluoride-containing phosphoric acid of this temperature is brought into contact with the silicon oxide films O1 and the silicon nitride films N1 formed on the substrate W. When the concentration of the fluoride in the fluoride-containing phosphoric acid is constant, the selectivity is not constant regardless of the temperature of the fluoride-containing phosphoric acid and increases or decreases in accordance with the temperature of the fluoride-containing phosphoric acid. Therefore, by controlling the temperature of the fluoride-containing phosphoric acid, the silicon oxide films O1 and the silicon nitride films N1 can be etched such that the selectivity is 1 or in a vicinity thereof or the silicon oxide films O1 and the silicon nitride films N1 can be etched such that the selectivity exceeds or falls below 1.

With the present embodiment, the fluoride-containing phosphoric acid of the etching temperature that contains ammonium fluoride or ammonium hydrogen difluoride is brought into contact with the silicon oxide films O1 and the silicon nitride films N1 formed on the substrate W. Thereby, the silicon oxide films O1 and the silicon nitride films N1 can be etched at equal or substantially equal etch rates. If the fluoride is a fluoride of an alkali metal such as sodium fluoride (NaF) or potassium fluoride (KF), there is a possibility of the substrate W becoming contaminated by the metal. There is no such possibility if the fluoride is ammonium fluoride or ammonium hydrogen difluoride. The silicon oxide films O1 and the silicon nitride films N1 can thus be etched as described above while preventing degradation of cleanness of the substrate W.

With the present embodiment, the temperature of the fluoride-containing phosphoric acid is adjusted such that the selectivity (etch rate of the silicon nitride films N1/etch rate of the silicon oxide films O1) takes on a value within the range of 0.9 to 1.1 and the fluoride-containing phosphoric acid of this temperature is brought into contact with the silicon oxide films O1 and the silicon nitride films N1 formed on the substrate W. The silicon oxide films O1 and the silicon nitride films N1 are etched at the selectivity within the range of 0.9 to 1.1. Thereby, it is prevented that the silicon nitride films N1 is etched at an etch rate greater than the etch rate of the silicon oxide films O1 while the silicon oxide films O1 is hardly etched as in when the silicon oxide films O1 and the silicon nitride films N1 are etched with a phosphoric acid not containing a fluoride.

With the present embodiment, the fluoride-containing phosphoric acid of the etching temperature is supplied into the memory hole 104 that penetrates through the plurality of silicon oxide films O1 and the plurality of the silicon nitride films N1 in the thickness direction Dt of the substrate W. The fluoride-containing phosphoric acid contacts the plurality of silicon oxide films O1 and the plurality of the silicon nitride films N1 that constitute the inner circumferential surface 105 of the memory hole 104 and etches these films. If the vertical cross section of the inner circumferential surface 105 of the memory hole 104 (the cross section of sectioning in the plane parallel to the thickness direction Dt of the substrate W and containing the center line of the memory hole 104) before etching is of a rectilinear shape, the vertical cross section of the inner circumferential surface 105 of the memory hole 104 changes to a wavy line shape in some cases where the inner circumferential surface 105 of the memory hole 104 is etched with the phosphoric acid not containing the fluoride. By supplying the fluoride-containing phosphoric acid of the etching temperature into the memory hole 104, such change can be prevented or alleviated.

With the present embodiment, the entirety of the range, in the thickness direction Dt of the substrate W, of a portion of the inner circumferential surface 105 of the memory hole 104 is covered with the protective substance such as the protective film 115, etc., before supplying the fluoride-containing phosphoric acid of the etching temperature into the memory hole 104 that changes in diameter in accordance with position in the thickness direction Dt of the substrate W and thereafter, the fluoride-containing phosphoric acid of the etching temperature is brought into contact with the remaining portion of the inner circumferential surface 105 of the memory hole 104 that is not covered by the protective substance. The remaining portion of the inner circumferential surface 105 of the memory hole 104 can thereby be etched selectively and the shape of the memory hole 104 can be changed intentionally.

With the present embodiment, the substrate W is heated and maintained at a constant temperature before the fluoride-containing phosphoric acid that is maintained at the etching temperature by heating is brought into contact with the substrate W. Thereby, the silicon oxide films O1 and the silicon nitride films N1 can be etched in a short time in comparison to a case where the fluoride-containing phosphoric acid of the etching temperature is supplied to the substrate W of room temperature. Further, the temperature of the substrate W before contact with the fluoride-containing phosphoric acid is stabilized and therefore, when a plurality of substrates W are successively brought into contact with the fluoride-containing phosphoric acid of the etching temperature, an etching amount can be stabilized among the plurality of substrates W.

### Other embodiments

The lateral cross section of the memory hole 104, that is, the cross section of the memory hole 104 along the plane orthogonal to the thickness direction Dt of the substrate W is not restricted to the circular shape and may be a shape other than the circular shape such as an elliptical or polygonal shape, etc.

The diameter of the memory hole 104 may decrease stepwise instead of continuously as the bottom of the memory hole 104 is approached. The inner circumferential surface 105 of the memory hole 104 may include a portion in which the diameter of the memory hole 104 decreases continuously as the bottom of the memory hole 104 is approached and a portion in which the diameter of the memory hole 104 decreases stepwise as the bottom of the memory hole 104 is approached.

The diameter of the memory hole 104 may increase continuously or stepwise from the frontmost surface 103 of the substrate W to the bottom of the memory hole 104 as the bottom of the memory hole 104 is approached. The inner circumferential surface 105 of the memory hole 104 may include a portion in which the diameter of the memory hole 104 increases continuously as the bottom of the memory hole 104 is approached and a portion in which the diameter of the memory hole 104 increases stepwise as the bottom of the memory hole 104 is approached.

The inner circumferential surface 105 of the memory hole 104 may include a portion in which the diameter of the memory hole 104 decreases continuously or stepwise as the bottom of the memory hole 104 is approached and a portion in which the diameter of the memory hole 104 increases continuously or stepwise as the bottom of the memory hole 104 is approached.

When an inner circumferential surface of a hole such as the memory hole 104 is etched with an etching liquid, the etch rate tends to decrease as the bottom of the memory hole 104 is approached because the etching liquid becomes less likely to be renewed as the bottom of the memory hole 104 is approached. If the diameter of the memory hole 104 increases as the bottom of the memory hole 104 is approached, variation in the diameter of the memory hole 104 can be alleviated by etching the inner circumferential surface 105 of the memory hole 104 with the fluoride-containing phosphoric acid. In this case, there is no need to protect the entrance side portion 105e of the inner circumferential surface 105 of the memory hole 104 from the fluoride-containing phosphoric acid with the protective film 115 and therefore, the filling liquid 111 and the protective liquid 114 described above do not have to be supplied to the substrate W.

The structure of the substrate W to which the fluoride-containing phosphoric acid of the etching temperature is supplied is not restricted to the structure shown in FIG. 1A, etc. A surface etched by the fluoride-containing phosphoric acid may be an inner circumferential surface of a hole other than the memory hole 104 or may be a side surface of a groove that penetrates in the thickness direction Dt of the substrate W through a plurality of silicon oxide films O1 and a plurality of silicon nitride films N1 that are laminated in the thickness direction Dt of the substrate W such that the silicon oxide films O1 and the silicon nitride films N1 are interchanged alternately. The surface etched by the fluoride-containing phosphoric acid may be a flat surface perpendicular to the thickness direction Dt of the substrate W.

In place of or in addition to heating the substrate W by contact of the heating liquid and the substrate W, the substrate W before etching with the fluoride-containing phosphoric acid may be heated by bringing a heating gas of higher temperature (for example, a temperature within a range of 100 to 150°C) than room temperature into contact with the substrate W. The heating gas may be an inert gas such as nitrogen gas, etc., or may be clean air (air filtered by a filter) or a gas other than these.

In place of or in addition to bringing the substrate W into contact with a heating fluid of higher temperature than room temperature such as the heating liquid or the heating gas, etc., the substrate W before etching with the fluoride-containing phosphoric acid may be heated by a heater that generates heat by supply of electric power. For example, such a heater may be disposed above or below the substrate W shown in FIG. 12.

The heating of the substrate W before etching may be omitted. That is, the fluoride-containing phosphoric acid of the etching temperature may be brought into contact with the substrate W of room temperature.

The substrate processing apparatus 1 is not restricted to an apparatus to process a disc-shaped substrate W, and may be an apparatus to process a polygonal substrate W.

Two or more arrangements among all the arrangements described above may be combined. Two or more steps among all the steps described above may be combined.

The embodiments of the present invention are described in detail above, however, these are just detailed examples used for clarifying the technical contents of the present invention, and the present invention should not be limitedly interpreted to these detailed examples, and the scope of the present invention should be limited only by the claims appended hereto.

### REFERENCE SIGNS LIST

- 1: : substrate processing apparatus

- 6: : chemical liquid processing bath
- 27: : heater
- 29: : chemical liquid nozzle
- 32: : pure water piping
- 35: : phosphoric acid piping
- 38: : fluoride piping
- 41: : mixing tank
- 67: : heating fluid nozzle
- 71: : chemical liquid nozzle
- 75: : rinse liquid nozzle
- 101: : base material
- 102: : laminated film
- 103: : frontmost surface of substrate
- 104: : memory hole
- 105: : inner circumferential surface of memory hole
- 111: : filling liquid
- 112: : filling substance
- 112r: : residual filling substance
- 113: : removing liquid
- 114: : protective liquid
- 115: : protective film
- 116: : thin film
- O1: : silicon oxide film
- N1: : silicon nitride film
- W: : substrate

## Claims

1. A substrate processing method comprising:
a phosphoric acid heating step of heating a fluoride-containing phosphoric acid that is a phosphoric acid containing a fluoride to maintain the fluoride-containing phosphoric acid at an etching temperature matching or approaching an isokinetic temperature at which an etch rate of a silicon oxide film and an etch rate of a silicon nitride film at a concentration of the fluoride in the fluoride-containing phosphoric acid are equal to each other; and
a phosphoric acid supplying step of bringing the fluoride-containing phosphoric acid of the etching temperature into contact with the silicon oxide film and the silicon nitride film that are formed on a substrate to etch the silicon oxide film and the silicon nitride film with the fluoride-containing phosphoric acid.

2. The substrate processing method according to Claim 1, wherein the fluoride is a compound that increases the etch rate of the silicon oxide film and the etch rate of the silicon nitride film.

3. The substrate processing method according to Claim 2, wherein when the concentration of the fluoride in the fluoride-containing phosphoric acid is constant, the etch rate of the silicon oxide film is greater than the etch rate of the silicon nitride film at a temperature lower than the isokinetic temperature and the etch rate of the silicon oxide film is less than the etch rate of the silicon nitride film at a temperature higher than the isokinetic temperature.

4. The substrate processing method according to Claim 1, wherein the fluoride is ammonium fluoride or ammonium hydrogen difluoride.

5. The substrate processing method according to any one of Claims 1 to 4, wherein a selectivity that represents a ratio of the etch rate of the silicon nitride film etched in the phosphoric acid supplying step with respect to the etch rate of the silicon oxide film etched in the phosphoric acid supplying step is within a range of 0.9 to 1.1.

6. The substrate processing method according to any one of Claims 1 to 4, wherein the substrate includes a plurality of the silicon oxide films and a plurality of the silicon nitride films that are laminated in a thickness direction of the substrate such that the silicon oxide films and the silicon nitride films are interchanged alternately and a hole that is recessed in the thickness direction from a frontmost surface of the substrate and penetrates through the plurality of silicon oxide films and the plurality of the silicon nitride films in the thickness direction and
the phosphoric acid supplying step includes a step of bringing the fluoride-containing phosphoric acid of the etching temperature into contact with the plurality of silicon oxide films and the plurality of the silicon nitride films that are exposed inside the hole.

7. The substrate processing method according to Claim 6, wherein a diameter of the hole changes in accordance with position in the thickness direction of the substrate.

8. The substrate processing method according to Claim 7, wherein the substrate processing method further comprises: an inner circumferential surface protecting step of covering a range, in the thickness direction of the substrate, of a portion of an inner circumferential surface of the hole with a protective substance of solid, liquid, or semisolid state that protects the silicon oxide film and the silicon nitride film from the fluoride-containing phosphoric acid; and
the phosphoric acid supplying step includes a step of bringing the fluoride-containing phosphoric acid of the etching temperature into contact with a remaining portion of the inner circumferential surface of the hole not covered by the protective substance while protecting the range of the portion from the fluoride-containing phosphoric acid of the etching temperature by the protective substance.

9. The substrate processing method according to any one of Claims 1 to 4, further comprising: a substrate heating step of heating the substrate to maintain the substrate at a constant temperature before bringing the fluoride-containing phosphoric acid of the etching temperature into contact with the silicon oxide film and the silicon nitride film formed on the substrate.

10. A substrate processing apparatus comprising:
a heater heating a fluoride-containing phosphoric acid that is a phosphoric acid containing a fluoride to maintain the fluoride-containing phosphoric acid at an etching temperature matching or approaching an isokinetic temperature at which an etch rate of a silicon oxide film and an etch rate of a silicon nitride film at a concentration of the fluoride in the fluoride-containing phosphoric acid are equal to each other; and
a chemical liquid nozzle discharging the fluoride-containing phosphoric acid of the etching temperature and by contact of the discharged fluoride-containing phosphoric acid of the etching temperature and the silicon oxide film and the silicon nitride film that are formed on a substrate, etches the silicon oxide film and the silicon nitride film with the fluoride-containing phosphoric acid.
